(19) Europäisches Patentamt
European Patent Office
Office européen des brevets

(11) EP 2 078 736 A1

(12) # EUROPEAN PATENT APPLICATION
published in accordance with Art. 153(4) EPC

(43) Date of publication:
**15.07.2009 Bulletin 2009/29**

(21) Application number: **07830402.9**

(22) Date of filing: **23.10.2007**

(51) Int Cl.:
***C08L 101/00*** *(2006.01)* ***C08K 3/00*** *(2006.01)*
***H01L 33/00*** *(2006.01)*

(86) International application number:
**PCT/JP2007/070668**

(87) International publication number:
**WO 2008/053753 (08.05.2008 Gazette 2008/19)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **31.10.2006 JP 2006296718**
**28.03.2007 JP 2007085721**

(71) Applicant: **Techno Polymer Co., Ltd.**
**Tokyo 104-0041 (JP)**

(72) Inventors:
- **FUJIOKA, Shinsuke**
  **Tokyo 104-0041 (JP)**
- **KITADA, Fusamichi**
  **Tokyo 104-0041 (JP)**

(74) Representative: **TBK-Patent**
**Bavariaring 4-6**
**80336 München (DE)**

(54) **HEAT-DISSIPATING RESIN COMPOSITION, SUBSTRATE FOR LED MOUNTING, REFLECTOR, AND SUBSTRATE FOR LED MOUNTING HAVING REFLECTOR PORTION**

(57) The objective of the present invention is to provide a heat-dissipating resin composition that is used for forming a substrate for LED mounting or a reflector provided on the substrate for LED mounting and is excellent in heat dissipation, electrical insulation, heat resistance and light resistance while an LED element emits light, a substrate for LED mounting and a reflector comprising the composition. The present composition comprises a thermoplastic resin such as modified PBT and a thermally conductive filler consisting of scaly boron nitride or the like, and has thermal deformation temperature of 120˚C or higher, a thermal conductivity of 2.0 W/(m•K) or higher, and a thermal emissivity of 0.7 or higher.

Figure 1

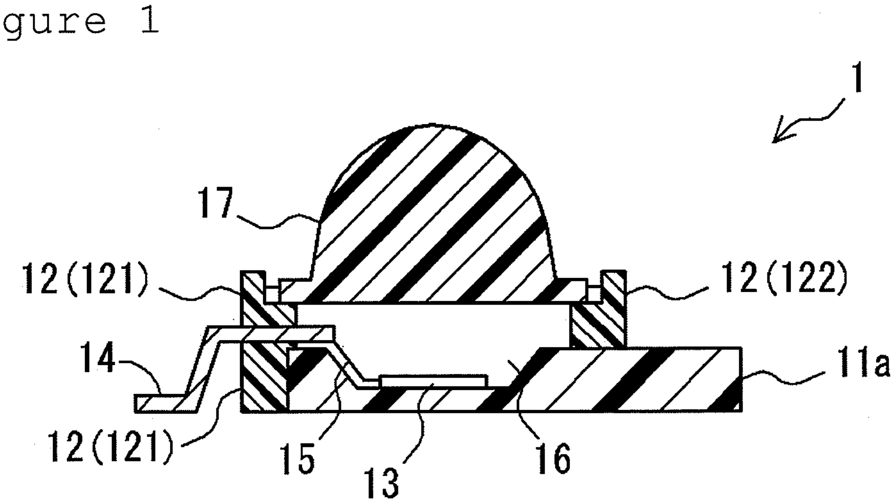




Printed by Jouve, 75001 PARIS (FR)

## Description

[Technical Field]

The present invention relates to a heat-dissipating resin composition and a molded article comprising the heat-dissipating resin composition. Specifically, the present invention relates to a heat-dissipating resin composition which is suitable for formation of a substrate for LED mounting and a reflector provided on this substrate for LED mounting that are constructing a surface-mounting LED package and to molded articles exemplified above.

[Background Art]

Since an LED element is conventionally compact and have a long life and low power consumption, it is utilized as a light source for an indication light or the like. Moreover, since an LED element of higher brightness has recently been produced at a relatively low price, it is considered to be utilized as a light source that can replace a fluorescent lamp and an incandescent light bulb. In the case where an LED element is applied as such a light source, in order to obtain a higher illumination, a surface-mounting LED package, in which, for example, a plurality of LED elements are placed on a base board (a substrate for LED mounting) formed of a metal such as aluminum and to dispose, around the LED elements, reflectors for reflecting light in a predetermined direction, is commonly used. However, since an LED element generates heat when it emits light, the temperature of such an LED illumination device is increased when the LED element emits light, and this causes the LED element to have a reduced brightness, a short life or the like. To overcome this disadvantage, there is proposed an LED illumination device in which a bare chip serving as an LED element is mounted on a base board formed of a high heat-dissipating metal and in which heat generated during emitting is diffused into the base board (described, for example in Patent Documents 1 and 2).

[Patent Document 1] Japanese Unexamined Patent Application Publication No. JP-A S62-149180
[Patent Document 2] Japanese Unexamined Patent Application Publication No. JP-A 2002-344031

[Problems to be solved by the Invention]

An objective of the present invention is to provide a heat-dissipating resin composition that is excellent in heat dissipation, electrical insulation (hereinafter referred to as "insulation"), heat resistance and light resistance while an LED element emits light in both cases of a substrate for LED mounting and a reflector that are constituting a surface-mounting LED package, and to provide a substrate for LED mounting and a reflector comprising such a heat-dissipating resin composition.

[Means for solving problems]

The present inventors studied diligently to overcome the foregoing disadvantage and found out that a composition containing a specific thermoplastic resin and a specific thermally conductive filler has excellent heat dissipation, insulation, heat resistance and light resistance while an LED element emits light in both cases of a substrate for LED mounting and a reflector that are comprising the composition.

The present invention is as follows.

1. A heat-dissipating resin composition used for forming a substrate for LED mounting or a reflector disposed on the substrate for LED mounting, characterized by comprising a thermoplastic resin and a thermally conductive filler, wherein the heat-dissipating resin composition has a thermal deformation temperature of 120˚C or higher, a thermal conductivity of 2.0 W/(m•K) or higher, and a thermal emissivity of 0.7 or higher.
2. The heat-dissipating resin composition according to 1 above, wherein a content of the thermally conductive filler is in the range from 20% to 90% by weight based on 100% by weight of a total of the thermoplastic resin and the thermally conductive filler.
3. The heat-dissipating resin composition according to 1 or 2 above, wherein the heat-dissipating resin composition is electrically insulated.
4. The heat-dissipating resin composition according to 1 to 3 above, wherein a content of iron oxide in the thermally conductive filler is 0.01% or less by weight.
5. The heat-dissipating resin composition according to 1 to 4 above, wherein the thermally conductive filler is scaly.
6. The heat-dissipating resin composition according to 1 to 5 above, wherein the thermally conductive filler is of boron nitride.

7. The heat-dissipating resin composition according to 1 to 6 above, wherein the thermoplastic resin is a polyester resin, a polycarbonate resin, a polyamide-based polymer or a mixture containing at least two types selected from the group consisting of a rubber-reinforced resin, a polyester resin, a polycarbonate resin and a polyamide-based polymer.
8. The heat-dissipating resin composition according to 7 above, wherein the polyester resin comprises a copolymeric polyester.
9. The heat-dissipating resin composition according to 8 above, wherein the copolymeric polyester comprises a copolymer-type polybutylene terephthalate.
10. The heat-dissipating resin composition according to 1 to 9 above, further comprising a flame retardant.
11. The heat-dissipating resin composition according to 1 to 10 above, further comprising a ultraviolet absorber and/or a light stabilizer in an amount from 0.05 to 10 parts by weight based on 100 parts by weight of a total of the thermoplastic resin and the thermally conductive filler.
12. The heat-dissipating resin composition according to 11 above, wherein the light stabilizer is a hindered amine-based compound having the following structure;

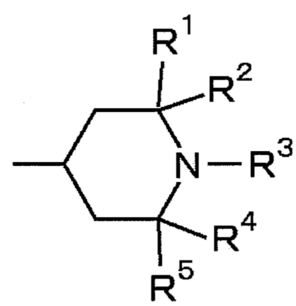

wherein $R^1$, $R^2$, $R^3$, $R^4$ and $R^5$ are either the same as each other or different from each other and are an alkyl group having 1 to 10 carbon atoms, an aryl group having 6 to 20 carbon atoms or an aralkyl group having 7 to 20 carbon atoms.
13. The heat-dissipating resin composition according to 1 to 12 above, wherein bending distortion is 1.5% or higher and whiteness is 80% or higher.
14. A substrate for LED mounting characterized by comprising the heat-dissipating resin composition according to 1 to 13 above.
15. A reflector characterized by comprising the heat-dissipating resin composition according to 1 to 13 above.
16. A substrate for LED mounting having a reflector portion characterized by comprising the heat-dissipating resin composition according to 1 to 13 above.

[Effects of the Invention]

According to the heat-dissipating resin composition of the present invention, moldability and impact resistance are excellent. And both in the case of a substrate for LED mounting and in the case of a reflector, heat dissipation, insulation, heat resistance and light resistance are superior while an LED element emits light.
In the case where the content of the iron oxide is 0.01% or less by weight in the thermally conductive filler, the composition has excellent whiteness and thus the light reflective characteristic is more excellent.
Additionally, in the case where the thermally conductive filler is of boron nitride, the heat dissipation, insulation, heat resistance and light reflective characteristic while an LED element emits light are more excellent. Accordingly, in the substrate for LED mounting and the reflector comprising the heat-dissipating resin composition of the present invention, since the temperature increase caused by heat generated when the LED element emits light is prevented by heat dissipation, does not cause the brightness to be reduced, and this makes it possible to extend the life of the LED element.
Moreover, in the case where an LED element and the like are embedded on the substrate for LED mounting formed using the heat-dissipating resin composition containing a hindered amine-based compound having a specific structure as a light stabilizer, an LED illumination device can be obtained in which a transparent sealant composition containing a silicone and the like has excellent curability and its mechanical strength is excellent.
According to the substrate for LED mounting of the present invention, the heat dissipation, insulation, heat resistance and light resistance while the LED element emits light are excellent. According to the reflector of the present invention, the heat dissipation, insulation, heat resistance, light reflective characteristic and light resistance while the LED element emits light are excellent. When the heat-dissipating resin composition of the present invention is used, an

integrally molded article can be obtained in which a substrate and a reflector portion are continuous and thus its productivity is excellent, with the result that the productivity of the LED illumination device is excellent.

[Brief Description of the Drawings]

FIG. 1 is a schematic diagram showing an example of the cross-sectional structure of a surface-mounting LED package incorporating a substrate for LED mounting and a reflector of the present invention.
FIG. 2 is a schematic diagram showing another example of the cross-sectional structure of a surface-mounting LED package incorporating a substrate for LED mounting and a reflector of the present invention.
FIG. 3 is a schematic diagram showing another example of the cross-sectional structure of a surface-mounting LED package incorporating a substrate for LED mounting (a substrate for LED mounting having a reflector portion) of the present invention.
FIG. 4 is a schematic diagram showing an example of the cross-sectional structure of an LED illumination device incorporating a surface-mounting LED package.
FIG. 5 is a schematic diagram showing an example of the cross-sectional structure of a conventional surface-mounting LED package.
FIG. 6 is a diagram showing a test method for Example 23 and Comparative Example 5.

[Explanation of the Reference Numbers]

1: surface-mounting LED package, 11a: substrate for LED mounting, 11b: substrate for LED mounting having reflector portion, 11c: metallic substrate for LED mounting, 12: reflector, 12b: reflector portion, 13: LED element, 14: electrode, 15: electrically conductive lead, 16: transparent sealing portion (or space portion), 17: lens, 18: insulation mount, 2: LED illumination device, 21: substrate for illumination device, 22: wiring pattern, 3: conventional surface-mounting LED package, 4: test piece for heat-dissipation evaluation, 5: silicone rubber heater.

[Best Mode for Carrying out the Invention]

The invention is described in further detail.
In this specification, "(co)polymer(ize)" means homopolymer(ize) and copolymer(ize), and "(meth)acryl" means acryl and methacryl.

1. Heat-dissipating resin composition

The heat-dissipating resin composition of the present invention is suitable for formation of a substrate for LED mounting and a reflector, and is **characterized in that** the composition comprises a thermoplastic resin and a thermally conductive filler and that the composition has a thermal deformation temperature of 120˚C or higher, a thermal conductivity of 2.0 W/(m•K) or higher, and a thermal emissivity of 0.7 or higher.
The above-mentioned substrate for LED mounting may be an embodiment in which an LED element, a lens, a reflector and other components can be provided on one surface thereof (See, reference numeral 11a in FIG. 1), or an embodiment in which a substrate and a reflector (a reflector portion) are continuous and an LED element, a lens and other components are provided within the reflector portion and on the surface (the upper surface shown in FIG. 3) of the substrate (See, reference numeral 11b in FIG. 3; this is hereinafter referred to as an "substrate for LED mounting having a reflector portion").
In FIG. 1 and other drawings, the LED element 13 is mounted on the substrate with an electrically conductive lead 15 by wire bonding. It may be mounted, through a bump on the substrate, on a wiring pattern placed near the LED element 13 by flip chip bonding.

1-1. Thermoplastic resin

The thermoplastic resin is not particularly limited so long as the rasin contains a thermoplastic polymer. Example thereof includes a polyester resin; a polycarbonate resin; a rubber-reinforced resin such as an ABS resin, an ASA resin and an AES resin; a styrene-based (co)polymer such as polystyrene, styrene•acrylonitrile copolymer, styrene•maleic anhydride copolymer and (meth)acrylate•styrene copolymer; an olefin-based resin such as polyethylene and polypropylene; a polyarylate resin; a polyamide-based polymer; a polyacetal resin; a poly vinyl chloride-based resin such as poly vinyl chloride, ethylene•vinyl chloride copolymer, and poly vinylidene chloride; an acrylic resin including a (co)polymer obtained using at least one (meth)acrylic ester, such as poly methyl methacrylate; a poly phenylene ether; a poly phenylene sulfide; a fluorine resin such as poly tetrafluoroethylene and poly vinylidene fluoride; a liquid crystal polymer; a polyimide-based resin such as polyimide, polyamide imide and polyether imide; a ketone-based resin such as polyether ketone and polyetherether ketone; a sulfone-based resin such as polysulfone and polyether sulfone; a urethane-based resin; a poly vinyl acetate; a polyethylene oxide; a poly vinyl alcohol; a poly vinyl ether; a poly vinyl butylal; a phenoxy resin; a photosensitive resin; a biodegradable plastic and the like. The thermoplastic resin may be used singly or in combination of two or more types thereof. In addition, a polyester resin, a polycarbonate resin; a polyamide-based polymer; a mixture containing at least two resins selected from a rubber-reinforced resin, a polyester resin, a polycarbonate resin and a polyamide-based polymer are preferable among the above-exemplified resins. The mixture is preferably an alloy of a polyester resin and a polycarbonate resin; an alloy of a rubber-reinforced resin and a polycarbonate resin; and an alloy of a rubber-reinforced resin, a polyester resin and a polycarbonate resin.

1-1-1. Polyester resin

The polyester resin is not particularly limited so long as the resin has an ester bond in the main chain of its molecule. The polyester resin may be a saturated polyester resin or an unsaturated polyester resin. Among these, a saturated polyester resin is preferable. The polyester resin may be either a homo-type polyester or a copolymeric polyester. In the present invention, the polyester resin preferably contains a copolymeric polyester due to excellent bending distortion. As a result, when a molded article comprising the heat-dissipating resin composition of the present invention, which serve a variety of members, are fitted, incorporated or otherwise handled, it is possible to prevent the members from being broken or damaged and to provide excellent workability and handling efficiency.
Moreover, the polyester resin may be a crystalline resin or an amorphous resin.

The above-mentioned polyester resin may be used that is obtained by, for example, polycondensation of a dicarboxylic acid component and a dihydroxy component or polycondensation of an oxycarboxylic acid component or a lactone component.
Examples of the above-mentioned dicarboxylic acid component include an aromatic dicarboxylic acid having about 8 to 16 carbon atoms and its derivative, such as terephthalic acid, isophthalic acid, phthalic acid, naphthalene dicarboxylic acid (including 2,6-naphthalene dicarboxylic acid), diphenyl dicarboxylic acid, diphenylether dicarboxylic acid, diphenylmethane dicarboxylic acid, diphenylethane dicarboxylic acid, diphenylketone dicarboxylic acid and 4,4'-diphenyl sulfone dicarboxylic acid; an alicyclic dicarboxylic acid having about 8 to 12 carbon atoms and its derivative, such as cyclohexane dicarboxylic acid (including 1,2-cyclohexane dicarboxylic acid, 1,3-cyclohexane dicarboxylic acid, 1,4-cyclohexane dicarboxylic acid and the like), hexahydrophthalic acid, hexahydroisophthalic acid and himic acid; and an aliphatic dicarboxylic acid having about 2 to 40 carbon atoms and its derivative, such as adipic acid, pimelic acid, suberic acid, azelaic acid, sebacic acid, dodecane dicarboxylic acid, hexadecane dicarboxylic acid and dimer acid, and the like.

The above-mentioned derivative includes a derivative that can form an ester, for example, a lower alkyl ester such as dimethyl ester, an acid anhydride, an acid halide such as acid chloride, and the like.
The dicarboxylic acid component may be used singly or in combination of two or more types thereof.

Additionally, examples of the above-mentioned dihydroxy component include an aliphatic alkylene glycol such as an alkylene glycol having a straight chain or branched chain of about 2 to 12 carbon atoms, including ethylene glycol, 1,2-propanediol, 1,3-propanediol, 1,3-butanediol, 1,4-butanediol, 1,5-pentanediol, neopentyl glycol, 1,6-hexanediol, 1,8-octanediol and decanediol; an aliphatic diol such as 1,2-cyclohexane diol, 1,4-cyclohexane diol, 1,1-cyclohexane dimethylol, 1,4-cyclohexane dimethylol and a hydrogenated bisphenol A; an aromatic diol such as hydroquinone, resorcin, dihydroxybiphenyl, naphthalene diol, dihydroxy diphenyl ether, bisphenol A and an adduct (for example, a diethoxylated bisphenol A) obtained by adding alkylene oxide such as ethylene oxide and propylene oxide to bisphenol A; a polyoxyalkylene glycol such as diethylene glycol, triethylene glycol, polyoxyethylene glycol, ditetramethylene glycol, polytetramethylene glycol, dipropylene glycol, tripropylene glycol, polyoxypropylene glycol and polytetramethylene ether glycol; and the like.

The above-mentioned dihydroxy component may have a substituent group such as an alkyl group, an alkoxy group and a halogen atom.
The above-mentioned dihydroxy component may be used singly or in combination of two or more types thereof.

Examples of the above-mentioned oxycarboxylic acid component include an oxycarboxylic acid such as oxybenzoic acid, oxynaphthoic acid and diphenylene oxycarboxylic acid and a derivative thereof, and the like.
The above-mentioned oxycarboxylic acid component may be used singly or in combination of two or more types thereof.

Examples of the above-mentioned lactone component include propiolactone, butyrolactone, valerolactone and ε-caprolactone.
The above-mentioned lactone component may be used singly or in combination of two or more types thereof.

When the above-mentioned polyester resin is a homo-type polyester, example thereof includes a polyalkylene terephthalate such as polyethylene terephthalate (PET), polypropylene terephthalate (PPT), polybutylene terephthalate

(PBT), polyhexamethylene terephthalate, polycyclohexane-1,4-dimethylterephthalate and polyneopentyl terephthalate, polyethylene isophthalate, a polyalkylene naphthalate such as polyethylene naphthalate, polybutylene naphthalate and polyhexamethylene naphthalate. As the above-mentioned homo-type polyester, polybutylene terephthalate (PBT) is preferred. In addition, these may be used singly or in combination of two or more types thereof.

When the above-mentioned polyester resin is a copolymeric polyester, typical example of the dicarboxylic acid component that is used to form the polyester resin includes an aromatic dicarboxylic acid such as terephthalic acid and isophthalic acid; an aliphatic dicarboxylic acid such as adipic acid, pimelic acid, suberic acid, azelaic acid and sebacic acid; and the like. Additionally, typical example of the dihydroxy component includes an aliphatic alkylene glycol such as a straight-chain alkylene glycol including ethylene glycol, propylene glycol and 1,4-butane diol; a polyoxyalkylene glycol containing a poly(oxy-alkylene) unit and having about 2 to 4 repeating units of oxyalkylene, such as diethylene glycol and polytetramethylene glycol, and the like.

Moreover, other than the above-mentioned compounds, as required, one or more compounds selected from the group consisting of the following compounds may be used as components for polycondensation: a monofunctional component and an ester derivative thereof such as a hydroxycarboxylic acid including glycolic acid, m-hydroxybenzoic acid, p-hydroxybenzoic acid, 6-hydroxy-2-naphthalenecarboxylic acid and p-β-hydroxyethoxy hydroxybenzoic acid and stearyl alcohol, benzyl alcohol, stearic acid, benzoic acid, tert-butyl benzoic acid and benzoylbenzoic acid; a polycarboxylic acid such as tricarballylic acid, trimellitic acid, trimesic acid and pyromellitic acid; a polyalcohol such as glycerin, trimethylolethane, trimethylolpropane, glycerol and pentaerythritol; a multifunctional component having three or more functional groups, such as gallic acid, and an ester derivative thereof.

In the present invention, preferable copolymeric polyester is a polymer that is obtained by polycondensation or the like of a dicarboxylic acid component mainly containing terephthalic acid and/or its derivative (including a lower alkyl ester such as dimethyl ester thereof, an acid anhydride, an acid halides such as acid chloride, and the like) and a dihydroxy component containing 1,4-butanediol, namely, and is a copolymer-type polybutylene terephthalate having glass transition temperature preferably in the range from 0˚C to 75˚C; a copolymer-type polyethylene terephthalate obtained by polycondensation or the like of a dicarboxylic acid component mainly containing terephthalic acid and/or its derivative (including a lower alkyl ester such as dimethyl ester thereof, an acid anhydride, an acid halides such as acid chloride, and the like) and a dihydroxy component containing ethylene glycol; and the like. Among these, a copolymer-type polybutylene terephthalate is particularly preferable. It is known that the copolymer-type polybutylene terephthalate is substantially more flexible than the above-mentioned polybutylene terephthalate (PBT), and it is also referred to as "soft PBT."

The dicarboxylic acid component used for the production of the above-mentioned copolymer-type polyethylene terephthalate contains terephthalic acid and/or its derivative of preferably 30% or more by weight, more preferably 40% or more by weight, and further preferably 50% or more by weight with respect to the total amount of the dicarboxylic acid component. Examples of the dicarboxylic acid component other than terephthalic acid and its derivative include isophthalic acid and the like, as described above. The other dicarboxylic acid component may be used singly or in combination of two or more types thereof.

The dihydroxy component used for the production of the above-mentioned copolymer-type polyethylene terephthalate contains 1,4-butanediol of preferably 10% or more by weight, more preferably 30% or more by weight, and further preferably 50% or more by weight with respect to the total amount of the dihydroxy component. Examples of the dihydroxy component other than 1,4-butanediol include an aliphatic alkylene glycol such as a straight-chain or branched chain alkylene glycol having about 2 to 12 carbon atoms, including ethylene glycol; an aromatic diol; a polyoxyalkylene glycol; and the like, as described above. The other dihydroxy component may be used singly or in combination of two or more types thereof.

In the present invention, preferable copolymer-type polybutylene terephthalate is exemplified below and is preferably a polymer that is obtained by polycondensation of a dicarboxylic acid component containing terephthalic acid and/or its derivative of 50% or more by weight and a dihydroxy component containing 1,4-butanediol and other dihydroxy components and containing 1,4-butanediol of preferably 50% to 90% by weight, and more preferably 60% to 90% by weight, wherein the above-mentioned other dihydroxy component is preferably a polyoxyalkylene glycol containing a poly(oxy-alkylene) unit and having about 2 to 4 repeating units of oxyalkylene, such as diethylene glycol and polytetramethylene glycol.

(1) A polymer obtained by polycondensation of a dicarboxylic acid component consisting of terephthalic acid and/or its derivative and a dihydroxy component containing 1,4-butanediol and other dihydroxy components and containing 1,4-butanediol of 50% to 90% by weight, and more preferably 60% to 90% by weight.

(2) A polymer obtained by polycondensation of a dicarboxylic acid component consisting of terephthalic acid and/or its derivative of preferably 50% or more by weight, and more preferably 70% or more by weight and isophthalic acid and/or its derivative of preferably 50% or less by weight, and more preferably 30% or less by weight and a dihydroxy component containing 1,4-butanediol and other dihydroxy components and containing 1,4-butanediol of 50% to 90% by weight, and more preferably 60% to 90% by weight.

The glass transition temperature of the above-mentioned copolymer-type polybutylene terephthalate is preferably in the range from 0°C to 75°C. The lower temperature limit is higher than 0°C. Additionally, the upper temperature limit is preferably lower than 70°C, more preferably lower than 65°C, further preferably lower than 60°C, and particularly lower than 50°C. If this glass transition temperature is too low, the molded article comprising a composition of the present invention has insufficient mechanical strength and heat resistance. On the other hand, if the temperature is too high, the composition decreases flexibility. The glass transition temperature can be measured by dynamic viscoelastic measurement.

In terms of moldability, the melting viscosity of the above-mentioned copolymer-type polybutylene terephthalate is preferably in the range from 400 to 2,500 Pa•s, and more preferably from 600 to 1,300 Pa•s when it is measured under conditions that the temperature is 250°C, the shear velocity is 91.2 (1/second), the bore of a nozzle is 1 mm $\phi$, the length of a flow path of the nozzle is 30 mm (L/D = 30).

The method for the production of the above-mentioned copolymer-type polybutylene terephthalate can be included: esterifying a raw material component comprising a dicarboxylic acid component containing terephthalic acid and/or its derivatives and a dihydroxy component containing 1,4-butanediol while stirring in the presence of a esterification reaction catalyst in one or more esterification reaction baths, for 2 to 5 hours, under conditions that the temperature is generally in the range from 150°C to 280°C, and preferably from 180°C to 265°C, the pressure is generally in the range from 50 to 1,000 Torr (6,666 to 133,322 Pa), and preferably from 70 to 760 Torr (9,333 to 101,325 Pa), and transferring the product (oligomer) of the esterification reaction to one or more polycondensation reaction baths, and polycondensating while stirring in the presence of a polycondensation reaction catalyst for 2 to 5 hours, under conditions that the temperature is generally in the range from 210°C to 280°C, and preferably from 220°C to 265°C, the pressure is generally 200 Torr (26,664 Pa) or less, and preferably 150 Torr (19,998 Pa) or less. The reactions may be continuous, semi-continuous or batch-wise.

The resin obtained by the polycondensation reaction is usually transferred from the bottom of the polycondensation reaction bath to a polymer-drawing-die where the resin is drawn in the form of strand, and, while being cooled by water or after being cooled by water, the resin is cut by a cutter into particles in the form of pellet, chip or the like.

Examples of the above-mentioned reaction catalyst for esterification include a titanium compound, a tin compound, a magnesium compound, a calcium compound, a zirconium compound and the like.

1-1-2. polycarbonate resin

This polycarbonate resin is not particularly limited so long as it has a carbonate bond in the principal chain, and it may be an aromatic polycarbonate or an aliphatic polycarbonate. Further, these may be used in combination. In the present invention, the aromatic polycarbonate is preferred from the aspect of impact resistance, heat resistance and the like. This polycarbonate resin may be one whose terminate is modified by an R-CO-group or an R'-O-CO-group (each of R and R' represents an organic group.). The polycarbonate resin may be used singly or in combination of two or more types thereof.

As the above-mentioned aromatic polycarbonate, one obtained by melting an aromatic dihydroxy compound and a carbonic acid diester to perform ester interchange (transesterification), one obtained by interfacial polymerization method using phosgene, one obtained by pyridine method using a reaction product of pyridine and phosgene, and the like may be used.

The aromatic dihydroxy compound may be one having two hydroxyl groups in the molecule. Example thereof includes dihydroxybenzene such as hydroquinone and resorcinol, 4,4'-biphenol, 2,2-bis(4-hydroxyphenyl) propane (hereinafter referred to as "bisphenol A"), 2,2-bis(3,5-dibromo-4-hydroxyphenyl) propane, 2,2-bis(4-hydroxyphenyl-3-methylphenyl) propane, 2,2-bis(3-tert-butyl-4-hydroxyphenyl) propane, 2,2-bis(3,5-dimethyl-4-hydroxyphenyl) propane, bis(4-hydroxyphenyl) methane, 1,1-bis(p-hydroxyphenyl) ethane, 2,2-bis(p-hydroxyphenyl) butane, 2,2-bis(p-hydroxyphenyl) pentane, 1,1-bis(p-hydroxyphenyl) cyclohexane, 1,1-bis(p-hydroxyphenyl)-4-isopropylcyclohexane, 1,1-bis(p-hydroxyphenyl)-3,3,5-trimethylcyclohexane, 1,1-bis(p-hydroxyphenyl)-1-phenylethane, 9,9-bis(p-hydroxyphenyl) fluorene, 9,9-bis(p-hydroxy-3-methylphenyl) fluorene, 4,4'-(p-phenylenediisopropylidene) diphenol, 4,4'-(m-phenylenediisopropylidene) diphenol, bis(p-hydroxyphenyl) oxide, bis(p-hydroxyphenyl) ketone, bis(p-hydroxyphenyl) ether, bis(p-hydroxyphenyl) ester, bis(p-hydroxyphenyl) sulfide, bis(p-hydroxy-3-methylphenyl) sulfide, bis(p-hydroxyphenyl) sulfone, bis(3,5-dibromo-4-hydroxyphenyl) sulfone, bis(p-hydroxyphenyl) sulfoxide and the like. These may be used singly or in combination of two or more types thereof.

Among the above-mentioned aromatic dihydroxy compound, a compound having a hydrocarbon group between two benzene rings is preferred. The hydrocarbon group in this compound may be a halogen-substituted hydrocarbon group. In addition, a hydrogen atom in the benzene ring may be replaced with a halogen atom. Therefore, examples of the above-mentioned compound include bisphenol A, 2,2-bis(3,5-dibromo-4-hydroxyphenyl)propane, 2,2-bis(4-hydroxyphenyl-3-methylphenyl)propane, 2,2-bis(3-tert-butyl-4-hydroxyphenyl)propane, 2,2-bis(3,5-dimethyl-4-hydroxyphenyl)propane, bis(4-hydroxyphenyl)methane, 1,1-bis(p-hydroxyphenyl)ethane, 2,2-bis(p-hydroxyphenyl)butane and the

like. Among these, bisphenol A is particularly preferred.

The carbonic acid diester used for obtaining the aromatic polycarbonate by transesterification includes dimethyl carbonate, diethyl carbonate, di-tert-butyl carbonate, diphenyl carbonate, ditolyl carbonate and the like. These may be used singly or in combination of two or more types thereof.

The viscosity-average molecular weight of the above-mentioned polycarbonate resin is preferably in the range from 12,000 to 40,000, more preferably from 14,000 to 30,000, and particularly from 16,000 to 26,000 when conversion is performed from the viscosities of solutions measured using methylene chloride as a solvent at a temperature of 20˚C. If the viscosity-average molecular weight is too high, fluidity is insufficient and moldability may be degraded. On the other hand, if the viscosity-average molecular weight is too low, impact resistance, rigidity and chemical resistance may be insufficient.

The polycarbonate resin may be obtained by mixing two or more types of polycarbonate resins having different viscosity-average molecular weights so long as the viscosity-average molecular weight of the entire polycarbonate resin falls within the above-mentioned range.

The above-mentioned polycarbonate resin can be used, as described above, in combination with a polyester resin and/or a rubber-reinforced resin as an alloy.

1-1-3. Polyamide-based polymer

The polyamide-based polymer is not particularly limited so long as its main chain has an acid amide bond (-CO-NH-), and may be either a polyamide-based resin or a polyamide-based elastomer. These may be combined.

Examples of the above-mentioned polyamide-based resin include Nylon 4, 6, 7, 8, 11, 12, 4.6, 6.6, 6.9, 6.10, 6.11, 6.12, 6T, 6/6.6, 6/12, 6/6T, 6T/6I and the like. These may be used singly or in combination of two or more types thereof. The ends of the polyamide-based resin may be terminated by a carboxylic acid, an amine or the like. Examples of the carboxylic acid include an aliphatic monocarboxylic acid such as caproic acid, caprylic acid, capric acid, lauric acid, myristic acid, palmitic acid, stearic acid and behenic acid. Additionally, examples of the amine include an aliphatic primary amine such as hexylamine, octylamine, decylamine, lauryl amine, myristyl amine, palmityl amine, stearyl amine and behenyl amine, and the like.

The above-mentioned polyamide elastomer is one which includes, as a hard segment, an aminocarboxylic acid having six or more carbon atoms or lactam or a nylon mn salt (X) where $m + n \geqq 12$, and as a soft segment, a polyol (Y) such as a poly(alkylene oxide)glycol, whose content of the component (X) in the elastomer is preferably in the range from 10% to 95% by weight, more preferably from 20% to 90% by weight, and particularly from 30% to 80% by weight.

1-1-4. Rubber-reinforced resin

The rubber-reinforced resin is consisting of a rubber-reinforced vinyl-based resin (hereinafter referred to as "rubber-reinforced vinyl-based resin (A1)") obtained by polymerizing a vinyl-based monomer (hereinafter referred to as "vinyl-based monomer (b)") containing an aromatic vinyl compound in the presence of a rubbery polymer (hereinafter referred to as a "rubbery polymer (a)") or of a mixture of the rubber-reinforced vinyl-based resin (A1) and a (co)polymer (hereinafter referred to as "(co)polymer (A2)") of a vinyl-based monomer.

The rubbery polymer (a) may be a homopolymer or a copolymer and examples thereof include a diene-based polymer and a non-diene-based polymer. Additionally, the polymer may be used singly or in combination of two or more types thereof. Further, the rubbery polymer (a) may be a non-crosslinked polymer or a crosslinked polymer.

Examples of the above-mentioned diene-based polymer include a homopolymer such as polybutadiene and polyisoprene; a styrene•butadiene-based copolymer such as styrene•butadiene copolymer, styrene•butadiene•styrene copolymer and acrylonitrile•styrene•butadiene copolymer; a styrene•isoprene-based copolymer such as styrene•isoprene copolymer, styrene•isoprene•styrene copolymer and acrylonitrile•styrene•isoprene copolymer; a hydrogenated polymer of each (co)polymer as exemplified above; and the like.

In addition, examples of the above-mentioned non-diene-based polymer include an ethylene•$\alpha$-olefin copolymer such as ethylene•propylene copolymer and ethylene•butene-1 copolymer; ethylene•$\alpha$-olefin•non-conjugated diene copolymer such as ethylene•propylene•5-ethylidene-2-norbornen copolymer, ethylene•butene-1•ethylidene-2-norbornen copolymer, ethylene•propylene•dicyclopentadiene copolymer and ethylene•butene-1•dicyclopentadiene copolymer; a urethane rubber; an acryl-based rubber; a silicone rubber; a silicone-acryl-based IPN rubber and the like.

The above-mentioned copolymer may be a block copolymer or a random copolymer.

The size and shape of the above-mentioned rubbery polymer (a) are not particularly limited. The rubbery polymer (a) is preferably in the form of particles. The weight-average particle diameter thereof is preferably in the range from 30 to 2,000 nm, more preferably from 100 to 1,500 nm, and further preferably from 200 to 1,000 nm. If the weight-average particle diameter is smaller than 30 nm, impact resistance of a molded article tends to be inferior, whereas if

the weight-average particle diameter is larger than 2,000 nm, moldability and appearance of the molded article tends to be inferior. The weight-average particle diameter can be measured by a laser diffraction scattering method, a dynamic light scattering method and the like.

The above-mentioned rubbery polymer (a) is not limited so long as the weight-average particle diameter is in the above range, and one enlarged by a known method such as methods described in JP-A S61-233010, JP-A S59-93701, JP-A S56-167704 and the like may be used.

Examples of a method for the production of the above-mentioned rubbery polymer (a) include emulsion polymerization, solution polymerization and the like. Among these, emulsion polymerization is preferable because it allows easy adjustment of the average particle diameter or the like. In this case, the average particle diameter can be adjusted by selecting the type and formulating amount of an emulsifier, the type and formulating amount of an initiator, and production conditions such as polymerization period, polymerization temperature and stirring conditions. Another method of adjusting the average particle diameter (particle diameter distribution) is to blend two or more types of the rubbery polymers (a) having different particle diameters. The rubbery polymer (a) obtained by emulsion polymerization is suitable for producing the rubber-reinforced vinyl-based resin (A1) by emulsion polymerization.
In addition, when the rubbery polymer (a) is produced by solution polymerization or the like, it is possible to produce a polymer having a predetermined average particle diameter by a method such as re-emulsion. The dispersion solution of the rubbery polymer (a) obtained by re-emulsion is also suitable for producing the rubber-reinforced vinyl-based resin (A1) by emulsion polymerization.

The vinyl-based monomer (b) used for the formation of the above-mentioned rubber-reinforced vinyl-based resin (A1) may be only an aromatic vinyl compound (hereinafter, referred to as "aromatic vinyl compound (b1)") or be used the aromatic vinyl compound (b1) and a compound capable of copolymerizing with the above-mentioned aromatic vinyl compound such as a cyanidated vinyl compound, a (meth)acrylic acid ester, a maleimide-based compound and an acid anhydride. These may be used singly or in combination of two or more types thereof.
Accordingly, as the above-mentioned vinyl-based monomer (b), at least one aromatic vinyl compound (b1), or a monomer combining at least one aromatic vinyl compound with at least one compound capable of copolymerizable with the aromatic vinyl compound may be used.

The above-mentioned aromatic vinyl compound (b1) is not particularly limited so long as it is a compound having at least one vinyl bond and at least one aromatic ring. Example thereof includes styrene, α-methyl styrene, o-methyl styrene, p-methyl styrene, vinyl toluene, β-methyl styrene, ethyl styrene, p-tert-butyl styrene, vinyl xylene, vinyl naphthalene, monochlorostyrene, dichlorostyrene, monobromostyrene, dibromostyrene, fluorostyrene and the like. These may be used singly or in combination of two or more types thereof. In addition, styrene and α-methyl styrene are preferred among these.

Examples of the above-mentioned cyanidated vinyl compound include acrylonitrile, methacrylonitrile and the like. Among these, acrylonitrile is preferred. In addition, the compound may be used singly or in combination of two or more types thereof.
Examples of the above-mentioned (meth)acrylic acid ester compound include methyl methacrylate, ethyl methacrylate, n-propyl methacrylate, isopropyl methacrylate, n-butyl methacrylate, isobutyl methacrylate, tert-butyl methacrylate, methyl acrylate, ethyl acrylate, n-propyl acrylate, isopropyl acrylate, n-butyl acrylate, isobutyl acrylate, tert-butyl acrylate and the like. The compound may be used singly or in combination of two or more types thereof.

Examples of the above-mentioned maleimide-based compound include maleimide, N-methyl maleimide, N-butyl maleimide, N-phenyl maleimide, N-(2-methylphenyl)maleimide, N-(4-hydroxyphenyl)maleimide, N-cyclohexyl maleimide and the like. The compound may be used singly or in combination of two or more types thereof. Introduction of the monomer unit of a maleimide-based compound into a polymer can be applied to an imidization after copolymerization with maleic anhydride.
Examples of the acid anhydride include maleic anhydride, itaconic anhydride, citraconic anhydride and the like. The compound may be used singly or in combination of two or more types thereof.

Further, a vinyl-based compound having a functional group such as hydroxyl group, amino group, epoxy group, amide group, carboxyl group and oxazoline group may be used as necessary in addition to the above-mentioned compound. Example thereof include 2-hydroxyethyl methacrylate, 2-hydroxyethyl acrylate, hydroxystyrene, N,N-dimethylaminomethyl methacrylate, N,N-dimethylaminomethyl acrylate, N,N-diethyl-p-aminomethyl styrene, glycidyl methacrylate, glycidyl acrylate, 3,4-oxycyclohexyl methacrylate, 3,4-oxycyclohexyl acrylate, vinyl glycidyl ether, methallyl glycidyl ether, allyl glycidyl ether, methacrylamide, acrylamide, methacrylic acid, acrylic acid, vinyl oxazoline and the like. The compound may be used singly or in combination of two or more types thereof.

The vinyl-based monomer (b) used for forming the rubber-reinforced vinyl-based resin (A1) is preferably one of the combinations of the following compounds. In the case of using a cyanidated vinyl compound, the characteristic balance between chemical resistance and resistance to discoloration may be improved. (1) An aromatic vinyl compound and a cyanidated vinyl compound (2) An aromatic vinyl compound, a cyanidated vinyl compound and other compound

When an aromatic vinyl compound (b1) and other vinyl monomer (hereinafter referred to as "vinyl monomer

(b2)") are used in combination as the vinyl-based monomer (b), the polymerization ratio (b1) / (b2) of the aromatic vinyl compound (b1) and the vinyl-based monomer (b2) is preferably 2% to 95% by weight / 98% to 5% by weight, and more preferably 10% to 90% by weight / 90% to 10% by weight provided that the total of these is 100% by weight. If the using amount of the cyanidated vinyl compound (b1) is too little, moldability tends to be degraded. On the other hand, if it is excessive, the heat-dissipating resin composition of the present invention and a molded article comprising the heat-dissipating resin composition are likely to have insufficient chemical resistance and heat resistance.

When, as described previously, a rubber-reinforced resin is used as the thermoplastic resin, the rubber-reinforced resin may consist of only the rubber-reinforced vinyl-based resin (A1) or of a mixture of the rubber-reinforced vinyl-based resin (A1) and the (co)polymer (A2) obtained by polymerizing a vinyl monomer. As the vinyl monomer, a compound can be employed that is used for forming the rubber-reinforced vinyl-based resin (A1), specifically, one or more types of compounds selected from the group of an aromatic vinyl compound, a cyanidated vinyl compound, a (meta)acrylic acid ester compound, a maleimide compound, an acid anhydride and a compound having a functional group. Accordingly, the above-mentioned (co)polymer (A2) may be a polymer obtained by polymerizing a component having the same composition as the vinyl-based monomer (b) used for forming the rubber-reinforced vinyl-based resin (A1), a polymer obtained by polymerizing a monomer of different composition but of the same type or a monomer of different composition and type. The (co)polymer (A2) may contain two or more types of these polymers.

The above-mentioned (co)polymer (A2) is preferably a copolymer consisting of a unit derived from an aromatic vinyl compound and a unit derived from at least one vinyl monomer selected from the group consisting of a cyanidated vinyl compound, a (meth)acrylic acid ester compound and a maleimide-based compound. The contents of these units are respectively preferably in the range from 2% to 95% by weight and from 5% to 98% by weight, and more preferably from 10% to 90% by weight and from 10% to 90% by weight, provided that the total of these units is 100% by weight.

Accordingly, specific examples of the above-mentioned (co)polymer include acrylonitrile•styrene copolymer, acrylonitrile•α-methylstyrene copolymer, acrylonitrile•styrene•α-methylstyrene copolymer, acrylonitrile•styrene•methyl methacrylate copolymer, styrene•methyl methacrylate copolymer, acrylonitrile•styrene•N-phenyl maleimide copolymer and the like.

Next, methods of producing the rubber-reinforced vinyl-based resin (A1) and the (co)polymer (A2) will be described.

The above-mentioned rubber-reinforced vinyl-based resin (A1) can be produced by preferably emulsion polymerization, solution polymerization or bulk polymerization of a vinyl-based monomer (b) in the presence of a rubbery polymer (a). When the rubber-reinforced vinyl-based resin (A1) is produced, the reaction may be conducted by charging all of the vinyl-based monomer (b) at once in the presence of the whole amount of the rubbery polymer (a), or by charging the vinyl-based monomer (b) dividedly or successively. Additionally, these methods may be combined. Further, the reaction may be conducted by adding the whole amount or a part of the rubbery polymer (a) in the middle of the polymerization.

When the rubber-reinforced vinyl-based resin (A1) is produced in an amount of 100 parts by weight, the compounding amount of the rubbery polymer (a) is preferably in the range from 5 to 80 parts by weight, more preferably from 10 to 70 parts by weight, and further preferably from 15 to 60 parts by weight.

In the case of producing the rubber-reinforced vinyl-based resin (A1) by emulsion polymerization, a polymerization initiator, a chain-transfer agent (molecular weight adjuster), an emulsifier, water and the like are used.

Examples of the above-mentioned polymerization initiator include a redox-type initiator by combining an organic peroxide such as cumene hydroperoxide, diisopropylbenzene hydroperoxide and p menthane hydroperoxide, and a reducing agent such as sugar-containing pyrophosphoric acid formulation and sulfoxylate formulation; a persulfate such as potassium persulfate; a peroxide such as benzoyl peroxide (BPO), lauroyl peroxide, tert-butylperoxy laurate and tert-butylperoxy monocarbonate; and the like. These may be used alone or in combination of two or more types thereof. Further, the above-mentioned polymerization initiator is added into the reaction system all at once or continuously. In addition, the above-mentioned polymerization initiator is used usually in an amount from 0.1% to 1.5% by weight with respect to the total amount of the above-mentioned vinyl-based monomer (b).

Examples of the above-mentioned chain-transfer agent include a mercaptan such as octyl mercaptan, n-dodecyl mercaptan, tert-dodecyl mercaptan, n-hexyl mercaptan, n-hexadecyl mercaptan, n-tetradecyl mercaptan and tert-tetradecyl mercaptan; a terpinolene, α-methyl styrene dimer, and the like. These may be used alone or in combination of two or more types thereof. The above-mentioned chain-transfer agent is used usually in an amount from 0.05% to 2.0% by weight with respect to the total amount of the above-mentioned vinyl-based monomer (b).

Examples of the above-mentioned emulsifier in the case of emulsion polymerization include an anionic surfactant such as a sulfuric acid ester of a higher alcohol, an alkyl benzene sulfonate including sodium dodecylbenzene sulfonate, an aliphatic sulfonate including sodium lauryl sulfonate, a higher aliphatic carboxylate, and a phosphate-based compound; a nonionic surfactant such as alkyl ester or alkyl ether of polyethylene glycol; and the like. These may be used singly or in combination of two or more types thereof. The emulsifier is used usually in an amount from 0.3% to 5.0% by weight with respect to the total amount of the above-mentioned vinyl-based monomer (b).

A latex obtained by emulsion polymerization is usually subjected to solidification by a coagulant, the polymer

component is pulverized, and then the product is purified by rinsing and drying. The coagulant may be used an inorganic salt such as calcium chloride, magnesium sulfate, magnesium chloride and sodium chloride; an inorganic acid such as sulfuric acid and hydrochloric acid; an organic acid such as acetic acid and lactic acid; and the like.

In the case of a combination of plural rubber-reinforced vinyl-based resins (A1), blending may be conducted after the production of the resins. Other method is one where latexes containing resins respectively are produced, blending is conducted, and then coagulation is conducted to a mixed rubber-reinforced vinyl-based resin (A1).

When the rubber-reinforced vinyl-based resin (A1) is produced by solution polymerization or bulk polymerization, a known method can be applied. In the case where the rubber-reinforced vinyl-based resin (A1) is produced by solution polymerization and bulk polymerization, the rubbery polymer (a) obtained by any method may be used. Specifically, a latex (containing the particles of the rubbery polymer (a)) obtained by emulsion polymerization may be used as it is, or the rubbery polymer (a) obtained by removing its medium may be used. The rubbery polymer (a) obtained by solution polymerization may also be used as it is or re-emulsion solution may be used.

The graft ratio of the above-mentioned rubber-reinforced vinyl-based resin (A1) is preferably in the range from 10% to 200% by weight, more preferably from 15% to 150% by weight, and further preferably from 20% to 150% by weight. If the graft ratio of the above-mentioned rubber-reinforced vinyl-based resin (A1) is less than 10% by weight, appearance and impact resistance of the heat-dissipating resin composition and a molded article comprising the same of the present invention may be deteriorated. Additionally, if the graft ratio exceeds 200% by weight, moldability may be inferior.

Here, the graft ratio refers to a value obtained by the following equation:

$$\text{Graft ratio (\% by weight)} = \{(y - x)/x\} \quad 100,$$

where x (g) is the amount of the rubber component in 1 g of the above-mentioned rubber-reinforced vinyl-based resin (A1), and y (g) is the amount of the insoluble component when 1 g of the above-mentioned rubber-reinforced vinyl-based resin (A1) is dissolved in acetone (acetonitrile is used in the case where an acryl-based rubber is used as the rubbery polymer (a)).

In addition, the intrinsic viscosity [η] (measured in methylethylketone at a temperature of 30˚C) of a component dissolved by acetone (acetonitrile is used in the case where an acryl-based rubber is used as the rubbery polymer (a)) in the above-mentioned rubber-reinforced vinyl-based resin (A1) is preferably in the range from 0.1 to 1.0 dl/g, more preferably from 0.2 to 0.9 dl/g, and further preferably from 0.3 to 0.8 dl/g. When the intrinsic viscosity [η] is in the above-mentioned range, moldability of the heat-dissipating resin composition of the present invention is excellent and impact resistances of heat-dissipating resin composition of the present invention and the molded article comprising the compositon are excellent.

The above-mentioned graft ratio and intrinsic viscosity [η] can be easily controlled by changing types and formulating amounts of the polymerization initiator, the chain-transfer agent, the emulsifier, the solvent and the like used in producing the above-mentioned rubber-reinforced vinyl-based resin (A1), further polymerization period, polymerization temperature and the like.

The above-mentioned (co)polymer (A2) can be produced by polymerization of a monomer component using a polymerization initiator and the like that are used in production of the above-mentioned rubber-reinforced vinyl-based resin (A1) in solution polymerization, bulk polymerization, emulsion polymerization, suspension polymerization and the like, or in thermal polymerization where the polymerization initiator is not used. Also, these polymerizations may be in combination.

The intrinsic viscosity [η] (measured in methylethylketone at a temperature of 30˚C) of the above-mentioned (co)polymer (A2) is preferably in the range from 0.1 to 1.0 dl/g, and more preferably from 0.15 to 0.8 dl/g. When the intrinsic viscosity [η] is in the above-mentioned range, the characteristic balance between moldability and impact resistance is excellent. This intrinsic viscosity [η] of the (co)polymer (A2) can be controlled by adjusting the production condition, similar to the case in the above-mentioned rubber-reinforced vinyl-based resin (A1).

The intrinsic viscosity [η] (measured in methylethylketone at a temperature of 30˚C) of a component dissolved by acetone (acetonitrile is used in the case where an acryl-based rubber is used as the rubbery polymer (a)) in the above-mentioned rubber-reinforced resin is preferably in the range from 0.2 to 0.8 dl/g, and more preferably from 0.25 to 0.7 dl/g. When the intrinsic viscosity [η] is in the above-mentioned range, the characteristic balance between moldability and impact resistance is excellent.

Both in the case where the above-mentioned rubber-reinforced resin consists of only the rubber-reinforced vinyl-based resin (A1), and in the case where the above-mentioned rubber-reinforced resin consists of a mixture of the rubber-reinforced copolymeric resin (A1) and a (co)polymer (A2) obtained by polymerization of the vinyl-based monomer, the content of the rubbery polymer (a) in the heat-dissipating composition of the present invention is preferably in the

range from 3% to 40% by weight, more preferably from 5% to 35% by weight, and further preferably from 5% to 30% by weight. If the content of the rubbery polymer (a) is too little, impact resistance of the heat-dissipating composition of the present invention may be inferior, and if the content is too much, moldability, surface appearance of the molded article, rigidity, heat resistance and the like may be deteriorated.

In the present invention, the above-mentioned thermoplastic resin preferably includes a polyester resin and the content thereof is preferably 50% or more by weight, more preferably 60% or more by weight, and particularly 70% or by weight. When the polyester resin and other resin are used in combination, the other resin is preferably a polycarbonate resin, a rubber-reinforced resin or the like.

The above-mentioned polyester resin may be either a homo-type polyester excellent in heat resistance or a copolymeric polyester excellent in heat resistance and mechanical strength (including Charpy impact strength, bending distortion and the like), or a combination of both polyesters. The resin comprises preferably a copolymeric polyester and more preferably it contains a copolymer-type polybutylene terephthalate.

Thus, when the type and content of the above-mentioned polyester resin are selected and adjusted, it is possible to obtain a heat-dissipating resin composition having a characteristic balance.

1-2 Thermally conductive filler

This thermally conductive filler is consisting of a material having a thermal conductivity at a temperature of 25˚C of preferably 30 W/(m•K) or higher, more preferably 80 W/(m•K) or higher, further preferably 100 W/(m•K) or higher, and particularly 150 W/(m•K) or higher. The upper limit of the thermal conductivity is generally 1,000 W/(m•K). Examples of the thermally conductive filler according to the present invention include boron nitride, aluminum nitride, silicon nitride, zinc oxide, aluminum oxide, magnesium oxide, calcium titanate and the like from the viewpoint of highly insulation. Alternatively, a composite filler can be used in which a shell is formed by using a core of an inorganic-based particle other than the above-mentioned compounds or of an organic-based particle and coating the above-mentioned compounds on the core. Moreover, when an insulating thermally-conductive filler is used, an insulating heat-dissipating resin composition can be obtained. The surface specific resistance (an index for insulation; the higher value, the more excellent insulation) of the molded article comprising this heat-dissipating resin composition of the present invention is preferably $1 \times 10^{13}\ \Omega$ or higher, and more preferably $1 \times 10^{14}\ \Omega$ or higher. When it falls within this range, the insulation is excellent.

Moreover, the above-mentioned thermally conductive filler is preferably consisting of a material in white-based from the viewpoint of light reflective characteristic. Among the above-mentioned materials, boron nitride and zinc oxide are preferable and boron nitride is particularly preferred. When a filler consisting of boron nitride is used as the thermally conductive filler, it is possible to obtain a heat-dissipating resin composition having a high level of characteristic balance between insulation, heat dissipation, heat resistance and light reflective characteristic.

In the boron nitride, stable structures are known such as c-BN (zincblende structure), w-BN (wurtzite structure), h-BN (hexagonal crystal structure) and r-BN (rhombohedral system). In the present invention, any of these boron nitrides can be used, and the boron nitride of hexagonal crystal structure is preferred. When the boron nitride of hexagonal crystal structure is used, it is possible to reduce the wear of a molding machine and a mold used in production of a molded article.

The boron nitride of hexagonal crystal structure has a layered crystal structure, and is shaped in the form of a flat plate (scaly). It is said that, in the boron nitride having such a layered structure, its thermal conductivity in a direction (an a-axis direction) parallel to layers is about 30 times as high as that in a direction (a c-axis direction) perpendicular to the layers.

Additionally, known zinc oxide can be used, and zinc oxide coated with a silicone resin may be used.

When a combination of boron nitride and zinc oxide is used as the thermally conductive filler, the preferable content of boron nitride is in the range from 60% to 95% by weight, and more preferable from 70% to 90% by weight provided that the total content of these is 100% by weight. When the amount of boron nitride used falls within the above-mentioned range, a reflective characteristic and heat dissipation are excellent.

The shape of the thermally conductive filler is not particularly limited, and the filler can be shaped in spherical, linear (fibrous), plate-like (scaly), curved or the like. The thermally conductive filler may be of single-particle type or of granulated type (of coagulated with single particles). When the thermally conductive filler in scaly is used, a molded article having an excellent thermal conductivity and a satisfactory mechanical characteristic can be obtained, being favorable. In particular, when the thermally conductive filler is consisting of the scaly boron nitride, insulation is excellent. Since the boron nitride itself has a high whiteness, a molded article having a high whiteness is easily obtained and light reflective characteristic is excellent. Both when it is used as a reflector and when it is used as a substrate for LED mounting having a reflector portion, the light reflective characteristic is excellent while an LED element emits light.

The average particle diameter (or the average of the maximum lengths) of the above-mentioned thermally conductive filler is preferably in the range from 1 to 350 $\mu$m and more preferably from 2 to 200 $\mu$m. The aspect ratio is preferably three or more, more preferably five or more, and further preferably in the range from 6 to 20. Moreover, the purity is

preferably 98% or more, and more preferably 99% or more. When these characteristics fall within the above-mentioned ranges, the heat dissipation and whiteness are excellent. Additionally, the bulk density is preferably 0.8 $g/cm^2$ or less, and more preferably 0.7 $g/cm^2$ or less. When this characteristic falls within the above-mentioned range, it is possible to obtain a resin composition having excellent heat dissipation.

When the above-mentioned thermally conductive filler is consisting of boron nitride, the size thereof is selected according to the intended performance, productivity, cost and the like of a substrate for LED mounting and a reflector (a reflector portion).

The average particle diameter is generally in the range from 1 to 350 μm and preferably from 2 to 200 μm. When the average particle diameter falls within the above-mentioned range, it is possible to obtain a molded article having excellent heat dissipation, insulation and light reflective characteristic. When the average particle diameter falls within the above-mentioned range, boron nitrides having different diameters may be used in combination. The specific surface area is not particularly limited.

The content of iron oxide contained in the thermally conductive filler is preferably 0.01% or less by weight, and more preferably 0.001% or less by weight. If the content is excessive, a molded article tends to have a low whiteness.

The content of the thermally conductive filler contained in the heat-dissipating resin composition of the present invention is preferably in the range from 20% to 90% by weight, more preferably from 25% to 90% by weight, further preferably from 30% to 70% by weight, and particularly from 31% to 60% by weight, provided that the total amount of the thermoplastic resin and the thermally conductive filler is 100% by weight. If the content of the thermally conductive filler is excessive, moldability, impact resistance and bending distortion tend to be inferior, whereas, if the content is too little, heat dissipation tends to be inferior.

1-3. Additive

The heat-dissipating resin composition of the present invention can contain additives according to the objective, the application and the like. Examples of the additives include a filler, a thermal stabilizer, an antioxidizing agent, a ultraviolet absorber, a light stabilizer, an antiaging agent, an antistatic agent, a plasticizer, a lubricant, a flame retardant, a mold-releasing agent, an antibacterial agent, a coloring agent, a crystal nucleating agent, a fluidity modifier, an impact modifier, an ester exchange inhibitor and the like. When the heat-dissipating resin composition of the present invention is used for the formation of a reflector and the formation of a substrate for LED mounting having a reflector portion, an additive is preferably selected in order to allow the composition to maintain a whitish color. Additionally, when the heat-dissipating resin composition of the present invention is used for the formation of a substrate for LED mounting incorporating no reflector portion, a composition colored by an additive may be used.

Examples of the filler include talc, mica, clay, wollastonite, silica, calcium carbonate, glass fiber, glass beads, glass balloon, milled fiber, glass flake, aramid fiber, polyarylate fiber and the like. These may be used singly or in combination of two or more types thereof.

The content of the above-mentioned filler is usually in the range from 3 to 30 parts by weight with respect to 100 parts by weight of the above-mentioned thermoplastic resin.

Examples of the above-mentioned thermal stabilizer include a phosphite, a hindered phenol, a thioether and the like. These may be used singly or in combination of two or more types thereof.

The content of the above-mentioned thermal stabilizer is usually in the range from 0.1 to 5 parts by weight with respect to 100 parts by weight of the above-mentioned thermoplastic resin.

Examples of the above-mentioned antioxidant include a hindered amine, hydroquinones, a hindered phenol, a sulfur-containing compound and the like. These may be used singly or in combination of two or more types thereof.

The content of the above-mentioned antioxidant is usually in the range from 0.1 to 5 parts by weight with respect to 100 parts by weight of the above-mentioned thermoplastic resin.

Examples of the above-mentioned ultraviolet absorber include a benzophenone-based compound, a benzotriazole-based compound, a triazine-based compound, a salicylate-based compound, a cyanoacrylate-based compound, a benzoic acid-based compound, an oxalic anilide-based compound, a metallic complex salt of nickel compound, and the like. These may be used singly or in combination of two or more types thereof.

Examples of the benzophenone-based compound include 2,4-dihydroxy benzophenone, 2-hydroxy-4-methoxybenzophenone, 2,2'-dihydroxy-4-methoxybenzophenone, 2,2'-dihydroxy-4,4'-di methoxybenzophenone, a mixture of 2,2'-dihydroxy-4,4'-dimethoxybenzophenone and each of other 4-substituted benzophenones, 2-hydroxy-4-methoxy-2'-carboxybenzophenone, 2-hydroxy-4-methoxy-5-sulfobenzophenone trihydrate, 2-hydroxy-4-n-octoxybenzophenone, 2,2',4,4'-tetrahydroxybenzophenone, 4-dodecyloxy-2-hydroxybenzophenone, bis(5-benzoyl-4-hydroxy-2-methoxyphenyl)methane, 2-hydroxy-4-methoxybenzophenone-5-sulfonic acid and the like.

Examples of the benzotriazole-based compound include 2-(2'-hydroxy-5'-methylphenyl)benzotriazole, 2-(2'-hydroxy-3',5'-di-tert-butylphenyl)benzotriazole, 2-(2'-hydroxy-3'-tert-butyl-5'-methylphenyl)-5-chlorobenzotriazole, 2-(2'-hydroxy-3',5'-di-tert-butylphenyl)-5-chlorobenzotriazole, 2-(2'-hydroxy-5'-tert-octylphenyl)benzotriazole, 2-(2'-hydroxy-3',5'-di-tert-amylphenyl)benzotriazole, 2-(2'-hydroxy-3',5'-di-tert-butylphenyl)benzotriazole, 2-[2'-hydroxy-3'-(3'',4'',5'', 6''-tetrahydrophthalimidemethyl)-5'-methylphenyl] benzotriazole, 2,2'-methylenebis[4-(1,1,3,3-tetramethylbutyl)-6-(2H-benzotriazole-2-yl)phenol], and benzotriazole derivatives and the like.

Examples of the triazine-based compound include 2-(4,6-diphenyl-1,3,5-triazine-2-yl)-5-[(hexyl)oxy]-phenol, 2-[4-[(2-hydroxy-3-dodecyloxypropyl]oxy]-2-hydroxyphenyl]-4,6,-bis(2,4-dimethylphenyl)-1,3,5-triazine, 2-[4-[(2-hydroxy-3-tridecyloxypropyl]oxy]-2-hydroxyphenyl]-4,6,-bis(2,4-dimethylphenyl)-1,3,5-triazine, 2,4-bis(2,4-dimethylphenyl)-6-(2-hydroxy-4-isoctyloxyphenyl)-1,3,5-triazine, 2-[4-[(2-hydroxy-3-(2'-ethyl)hexyl)oxy]-2-hydroxyphenyl]-4,6-bis(2,4-dimethylphenyl)-1,3,5-triazine, 2,4-bis(2-hydroxy-4-butoxyphenyl)-6-(2,4-bisbutoxyphenyl)-1,3,5-triazine, 2-[2-hydroxy-4-(1-octyloxycarbonylethoxy)phenyl]-4,6-bis(4-phenylphenyl)-1,3,5-triazine; a modified compound, a polymer and a derivative formed by using one or more of these compounds; and the like.

Examples of the modified compound include a reaction product of 2-(4,6-bis(2,4-dimethylphenyl)-1,3,5-tiazine-2-yl)-5-hydroxyphenyl and an oxirane (for example, alkyloxymethyloxirane having 10 to 16 carbon atoms), a reaction product of 2-(2,4-dihydroxyphenyl)-4,6-bis-(2,4-dimethylphenyl)-1,3,5-triazine and (2-ethylhexyl) glycidic ester, and the like.

Examples of the salicylate-based compound include phenyl salicylate, p-tert-butylphenyl salicylate, p-octylphenyl salicylate, and the like.

Examples of the cyanoacrylate-based compound include 2-ethylhexyl-2-cyano-3,3-diphenylacrylate, ethyl-2-cyano-3,3-diphenylacrylate, α-cyano-β,β-diphenylethylacrylate, α-cyano-β,β-diphenylisooctylacrylate, and the like.

Examples of the benzoic acid-based compound include methyl o-benzoylbenzoate, resorcinol-monobenzoate, 2,4-di-tert-butylphenyl-3,5-di-tert-butyl-4-hydroxybenzoate, para-amino benzoic acid, para-amino benzoic acid monoglycerin ester, ethyl N,N-dipropoxy para-amino benzoate, ethyl N,N-diethoxy para-amino benzoate, methyl N,N-dimethyl para-amino benzoate, ethyl N,N-dimethyl para-amino benzoate, butyl N,N-dimethyl para-amino benzoate, and the like.

Examples of the oxalic anilide-based compound include 2-ethoxy-5-tertiary butyl-2'-ethyl oxalic bisanilide, 2-ethoxy-2-ethyl oxalic bisanilide, and the like.

Examples of the metallic complex salt include a nickel compound such as nickel bis-octylphenylsulfamide, [2,2'-thiobis(4-tert-octylphenolate)]-n-butylaminenickel, [2,2'-thiobis(4-tert-octylphenolate)]-2-ethylhexylaminenickel, nickel dibutyldithiocarbamate, a nickel salt of ethyl-3,5-di-tert-butyl-4-hydroxybenzylphosphoric acid, a nickeltiobisphenol complex, and the like.

Examples of other ultraviolet absorber include 1,3-bis-(4-benzoyl-3-hydroxyphenoxy)-2-propylacrylate, 1,3-bis-(4-benzoyl-3-hydroxyphenoxy)-2-propylmethacrylate, and the like.

Additionally, examples of the above-mentioned light stabilizer include a hindered amine-based compound, a semicarbazone-based compound and the like. These may be used singly or in combination of two or more types thereof.

Examples of the hindered amine-based compound include bis(2,2,6,6-tetramethyl-4-piperidyl)sebacate, bis(1,2,2,6,6-pentamethyl-4-piperidyl)sebacate, 1-[2-{3-(3,5-di-tert-butyl-4-hydroxyphenyl)propionyloxy}ethyl]-4-{3-(3,5-di-tert-butyl-4-hydroxyphenyl)propionyloxy}-2,2,6,6,-tetramethylpiperidine, 8-benzyl-7,7,9,9-tetramethyl-3-octyl-1,2,3-triazaspiro[4,5]undecane-2,4-dione, 4-benzoyloxy-2,2,6,6-tetramethylpiperidine, dimethyl succinate-1-(2-hydroxyethyl)-4-hydroxy-2,2,6,6-tetramethylpiperidine polycondensation product, poly[[6-(1,1,3,3-tetramethylbutyl)imino-1,3,5-triazine-2,4-diyl][(2,2,6,6-tetramethyl-4-piperidyl)imino]hexamethylene[[(2,2,6,6-tetramethyl-4-piperidyl) imino]], 2-(3,5-di-tert-butyl-4-hydroxybenzyl)-2-n-butyl-bis(1,2,2,6,6-pentamethyl-4-piperidyl)malonate, tetrakis(2,2,6,6-tetramethyl-4-piperidyl)-1,2,3,4-butanetetracarboxylate, a condensation product of 1,2,3,4-butanetetracarboxylic acid, 1,2,2,6,6-pentamethyl-4-piperidinol and tridecyl alcohol, a condensation product of 2,2,6,6,-tetramethyl-4-piperidinol and tridecyl alcohol, a condensation product of 1,2,3,4-butanetetracarboxylic acid, 1,2,2,6,6,-pentamethyl-4-piperidinol and β,β,β',β'-tetramethyl-3,9-(2,4,8,10-tetraoxaspiro[5.5]undecane)diethanol, a condensation product of 1,2,3,4-butanetetracarboxylic acid, 2,2,6,6,-tetramethyl-4-piperidinol and β,β,β',β'-tetramethyl-3,9-(2,4,8,10-tetraoxaspiro[5.5]undecane)diethanol, 1,2,2,6,6-pentamethyl-4-piperidylmethacrylate, 2,2,6,6-tetramethyl-4-piperidylmethacrylate, bis(1-octyloxy-2,2,6,6-tetramethyl-4-piperidyl)sebacate, 2-(3,5-di-tert-butyl-4-hydroxyphenyl)-2-n-butyl-bis(2,2,6,6-tetramethyl-4-piperidyl) malonate, 2-(3,5-di-tert-butyl-4-hydroxyphenyl)-2-n-butyl-bis(1,2,2,6,6-pentametyl-4-piperidyl)malonate, 2-(3,5-di-tert-butyl-4-hydroxybenzyl)-2-n-butyl-bis(2,2,6,6-tetramethyl-4-piperidyl)malonate, tetrakis(1,2,2,6,6-pentamethyl-4-piperidyl)-1,2,3,4-butanetetracarboxylate, 1,2-bis(3-oxo-2,2,6,6-tetramethyl-4-piperidyl)ethane, 1-(3,5-di-tert-butyl-4-hydroxyphenyl)-1,1-bis(2,2,6,6-tetramethyl-4-piperidyloxycarbonyl)pentane, poly[1-oxyethylene(2,2,6,6-tetramethyl-1,4-piperidyl)oxysuccinyl], poly[2-(1,1,4-trimethylbutylimino)-4,6-triazinediyl-(2,2,6,6-tetramethyl-4-piperidyl)iminohexamethylene-(2,2,6,6,-tetramethyl-4-piperidyl)imino], a condensation product of N,N'-bis(3-aminopropyl)ethylenediamine-2,4-bis[N-butyl-N-(2,2,6,6-tetramethyl-4-piperidyl)amino]-6-chloro-1,3,5-triazine, and the like.

The preferable light stabilizer is a hindered amine-based compound having the following structure:

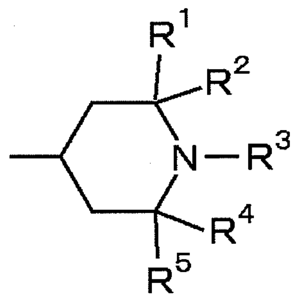

wherein $R^1$, $R^2$, $R^3$, $R^4$ and $R^5$ are either the same as each other or different from each other and are an alkyl group having 1 to 10 carbon atoms, an aryl group having 6 to 20 carbon atoms or an aralkyl group having 7 to 20 carbon atoms. The above-mentioned hindered amine-based compound having the structure are particularly tetrakis(1,2,2,6,6-pentamethyl-4-piperidyl)-1,2,3,4-butanetetracarboxylate, bis(1,2,2,6,6-pentamethyl-4-piperidyl)sebacate, 2-(3,5-di-tert-butyl-4-hydroxyphenyl)-2-n-butyl-bis(1,2,2,6,6-pentamethyl-4-piperidyl)malonate, 1,2,2,6,6-pentamethyl-4-piperidylmethacrylate, 2-(3,5-di-tert-butyl-4-hydroxybenzyl)-2-n-butyl-bis(1,2,2,6,6-pentamethyl-4-piperidyl)malonate, a condensation product of 1,2,3,4-butanetetracarboxylic acid, 1,2,2,6,6-pentamethyl-4-piperidinol and tridecyl alcohol, and a condensation product of 1,2,3,4-butanetetracarboxylic acid, 1,2,2,6,6,-pentamethyl-4-piperidinol and β,β,β',β'-tetramethyl-3,9-(2,4,8,10-tetraoxaspiro[5.5]undecane)diethanol that are ones wherein $R^3$ is methyl group, and the like.

The hindered amine-based compound is used as other functional additives such as an antioxidizing agent. Therefore, if the hindered amine-based compound is contained as an additive other than a light stabilizer, the hindered amine-based compound is considered to be contained as the light stabilizer, the hindered amine-based compound that is contained as an additive other than a light stabilizer is preferably the above-mentioned hindered amine-based compound having a specific structure.

Examples of the semicarbazone-based compound include 1,6-hexamethylenebis-(N,N-dimethylsemicarbazide), 1,1,1',1'-tetramethyl-4,4'-(methylenedi-p-phenylene)disemicarbazide, and the like.

When the above-mentioned ultraviolet absorber and/or the light stabilizer is used, it is possible to prevent failures caused when light from an LED element is received for a prolonged period, such as a decrease in the hue of the surface of a molded article and a decrease in a light reflective characteristic.

The content of the above-mentioned ultraviolet absorber and/or the light stabilizer is preferably in the range from 0.05 to 10 parts by weight, more preferably from 0.1 to 5 parts by weight and further preferably from 0.2 to 5 parts by weight provided that the total of the above-mentioned thermoplastic resin and the above-mentioned thermally conductive filler is 100 parts by weight. When the ultraviolet absorber and the light stabilizer are used in combination, improvement against the above-mentioned failures is significant. In this case, the contents of these components are preferably 5 to 95 parts by weight and 95 to 5 parts by weight, more preferably 10 to 90 parts by weight and 90 to 10 parts by weight, further preferably 15 to 85 parts by weight and 85 to 15 parts by weight, and particularly preferably 40 to 60 parts by weight and 60 to 40 parts by weight respectively, provided that total of these is 100 parts by weight.

Examples of the above-mentioned anti-aging agent include a naphtylamine-based compound, a diphenylamine-based compound, p phenylenediamine-based compound, a quinoline-based compound, a hydroquinone-based compound, a monophenol-based compound, a bisphenol-based compound, a trisphenol-based compound, a polyphenol-based compound, a thiobisphenol-based compound, a hindered phenol-based compound, a phosphate ester-based compound, an imidazol-based compound, a dithiocarbamic acid nickel salt-based compound, a phosphate-based compound and the like. These may be used singly or in combination of two or more types thereof.

The content of the above-mentioned anti-aging agent is usually in the range 0.1 to 5 parts by weight with respect to 100 parts by weight of the above-mentioned thermoplastic resin.

Examples of the above-mentioned plasticizer include a phthalate ester such as dimethyl phthalate, diethyl phthalate, dibutyl phthalate, dioctyl phthalate, butyl octyl phthalate, di-(2-ethylhexyl) phthalate, diisooctyl phthalate and diisodecyl phthalate; a fatty acid ester such as dimethyl adipate, diisobutyl adipate, di-(2-ethylhexyl) adipate, diisooctyl adipate, diisodecyl adipate, octyldecyl adipate, di-(2-ethylhexyl) azelate, diisooctyl azelate, diisobutyl azelate, dibutyl sebacate, di-(2-ethylhexyl) sebacate and diisooctyl sebacate; a trimellitic acid ester such as isodecyl trimellitate, octyl trimellitate, n-octyl trimellitate and isononyl trimellitate; di-(2-ethylhexyl) fumarate, diethylene glycol monooleate, glyceryl monoricinoleate, trilauryl phosphate, tristearyl phosphate, tri-(2-ethylhexyl)phosphate, an epoxidized soybean oil, a polyether ester and the like. These may be used singly or in combination of two or more types thereof.

The content of the above-mentioned plasticizer is usually in the range 0.1 to 15 parts by weight with respect to 100 parts by weight of the above-mentioned thermoplastic resin.

Examples of the above-mentioned lubricant include a fatty acid ester, a hydrocarbon resin, a paraffin, a higher

fatty acid, an oxyfatty acid, a fatty acid amide, an alkylenebisfatty acid amide, an aliphatic ketone, a fatty acid lower alcohol ester, a fatty acid polyalcohol ester, a fatty acid polyglycol ester, an aliphatic alcohol, a polyalcohol, a polyglycol, a polyglycerol, a metal soap, a silicone, a modified silicone and the like. These may be used singly or in combination of two or more types thereof.
The content of the above-mentioned lubricant is usually in the range 0.1 to 5 parts by weight with respect to 100 parts by weight of the above-mentioned thermoplastic resin.

The flame retardant includes an organic-based flame retardant, an inorganic-based flame retardant, a reactive flame retardant and the like. These may be used singly or in combination of two or more types thereof.
Examples of the organic-based flame retardant include a halogen-based flame retardant such as a brominated epoxy-based compound, a brominated alkyltriazine compound, a brominated bisphenol-based epoxy resin, a brominated bisphenol-based phenoxy resin, a brominated bisphenol-based polycarbonate resin, a brominated polystyrene resin, a brominated crosslinked polystyrene resin, a brominated bisphenol cyanurate resin, a brominated polyphenylene ether, a decabromodiphenyl oxide, and tetrabromobisphenol A and an oligomer thereof; a phosphorus-based flame retardant including a phosphoric acid ester such as trimethyl phosphate, triethyl phosphate, tripropyl phosphate, tributyl phosphate, tripentyl phosphate, trihexyl phosphate, tricyclohexyl phosphate, triphenyl phosphate, tricresyl phosphate, trixylenyl phosphate, cresyl diphenyl phosphate, dicresyl phenyl phosphate, dimethyl ethyl phosphate, methyl dibutyl phosphate, ethyl dipropyl phosphate and hydroxyphenyl diphenyl phosphate, as well as compounds obtained by modifying these compounds with various substituents, various condensed phosphoric acid ester compounds, and a phosphazene derivative comprising elemental phosphorus and nitrogen; polytetrafluoroethylene, a guanidine salt, a silicone-based compound, a phosphazene-based compound and the like. These may be used singly or in combination of two or more types thereof.

Examples of the inorganic flame retardant include aluminum hydroxide, antimony oxide, magnesium hydroxide, zinc borate, a zirconium-based compound, a molybdenum-based compound, zinc stannate and the like. These may be used singly or in combination of two or more types thereof.
Examples of the reactive flame retardant include tetrabromobisphenol A, dibromophenol glycidyl ether, a brominated aromatic triazine, tribromophenol, tetrabromophthalate, tetrachlorophthalic anhydride, dibromoneopentyl glycol, poly (pentabromobenzyl polyacrylate), chlorendic acid (HET acid), chlorendic anhydride (HET anhydride), brominated phenol glycidyl ether, dibromocresyl glycidyl ether and the like. These may be used singly or in combination of two or more types thereof.

The content of the above-mentioned flame retardant is usually in the range from 5 to 30 parts by weight, and preferably from 5 to 20 parts by weight with respect to 100 parts by weight of the above-mentioned thermoplastic resin. When the flame retardant is formulated in the heat-dissipating resin composition of the present composition, it is preferable that a flame retardant auxiliary is used together. Examples of the flame retardant auxiliary include an antimony compound such as diantimony trioxide, diantimony tetraoxide, diantimony pentoxide, sodium antimonite and antimony tartrate; zinc borate, barium metaborate, alumina hydrate, zirconium oxide, ammonium polyphosphate, tin oxide, and the like. These may be used singly or in combination of two or more types thereof.

Examples of anti-bacterial agent include an inorganic anti-bacterial agent such as a zeolite-based anti-bacterial agent including a silver-based zeolite, a silver-zinc-based zeolite and the like, a silica-gel-based anti-bacterial agent including a complexed-silver silica gel, a glass-based anti-bacterial agent, a calcium-phosphate-based anti-bacterial agent, a zirconium-phosphate-based anti-bacterial agent, a silicate anti-bacterial agent including silver-magnesium aluminate silicate, a titanium-oxide-based anti-bacterial agent, a ceramic-based anti-bacterial agent and a whisker-based anti-bacterial agent; , an organic anti-bacterial agent such as a formaldehyde emitter, a halogenated aromatic compound, a rhodopropargyl derivative, a thiocyanate compound, an isothiazolinone derivative, a trihalomethylthio compound, a quaternary ammonium salt, a biguanide compound, an aldehyde, a phenol, a benzimidazole derivative, a pyridine oxide, a carbanilide, a diphenyl ether, a carboxylic acid and an organic metal compound; an inorganic-organic hybrid anti-bacterial agent, a natural anti-bacterial agent and the like. These may be used singly or in combination of two or more types thereof.
The content of the above-mentioned anti-bacterial agent is usually in the range 0.05 to 5 parts by weight with respect to 100 parts by weight of the above-mentioned thermoplastic resin.

As the above-mentioned coloring agent, an inorganic pigment such as $TiO_2$, an organic pigment or dye may be used. Alternatively, they may be used in combination.
The content of the above-mentioned coloring agent is preferably in the range from 0.05 to 30 parts by weight, more preferably from 0.1 to 15 parts by weight, and further preferably from 0.1 to 10 parts by weight provided that the content of the above-mentioned thermoplastic resin is 100 parts by weight.
Examples of the above-mentioned impact modifier include a grafted rubber and the like.

The above-mentioned ester exchange inhibitor can be contained when a polyester resin is used as the thermoplastic resin. The ester exchange inhibitor is not particularly limited, and a phosphate-based compound having a P-O bond is preferably used. Specific examples include phosphoric acid, phosphorous acid, phosphonic acid, hypophosphorous acid and pyrophosphoric acid, and their derivatives, a silylphosphate and the like.
The content of the above-mentioned ester exchange inhibitor is preferably in the range from 0.01 to 5 parts by weight, more preferably from 0.02 to 3 parts by weight, and further preferably from 0.03 to 1 part by weight provided that the content of the thermoplastic resin is 100 parts by weight. When the ester exchange inhibitor is used within this range, it is possible to prevent degradation caused by heat generated during molding and to obtain a molded article having excellent impact resistance, whiteness and gloss.

1-4. Method of producing the composition

The heat-dissipating resin composition of the present invention can be produced by supplying a raw material which is weighed so that the material has the above-mentioned predetermined composition, to an extruder, a Banbury mixer, a kneader, a roller, a feeder/ruder or the like, and kneading it. The method of supplying the raw material is not particularly limited. The components may be kneaded in one batch, or the components may be supplied dividedly or with multi-step to be kneaded.
The kneading temperature is selected according to the type of the thermoplastic resin and the content of the thermally conductive filler and is typically in the range from 200˚C to 300˚C.

1.5. Characteristics of the composition

In the heat-dissipating resin composition of the present invention, the thermoplastic resin serves as a matrix and the thermally conductive filler is evenly dispersed therein. Thus the composition is excellent in moldability and leads to a molded article excellent in impact resistance irrespective of the content of the thermally conductive filler. Additionally, the molded article comprising the heat-dissipating resin composition of the present invention has excellent heat dissipation, insulation, heat resistance and light resistance. When the thermally conductive filler is consisting of boron nitride, the composition is particularly superior in insulation and light reflective characteristic.
In the heat-dissipating resin composition of the present invention, the thermal deformation temperature (under a load of 1.80 MPa) according to ISO 75 is 120˚C or higher, preferably in the range from 130˚C to 300˚C, and more preferably from 130˚C to 280˚C. If this temperature is lower than 120˚C, a deformation resulting from heat caused by light emission of an LED tends to be generated.
This thermal deformation temperature can be adjusted by selecting, as appropriate, the type and content of the thermoplastic resin, the type, shape and content of the thermally conductive filler, and the like.
In addition, the thermal conductivity at a temperature of 25˚C is 2.0 W/(m•K) or higher, preferably in the range from 3.0 to 10.0 W/(m•K), and more preferably from 4.0 to 5.0 W/(m•K). When the above-mentioned thermal conductivity falls within this range, the characteristic balance between heat dissipation and mechanical strength is excellent. If this thermal conductivity is less than 2.0 W/(m•K), the heat dissipation tends to be inferior. It is noted that the above-mentioned thermal conductivity is one measured with respect to a direction in which the composition used when a molded article was produced flew, and its measurement method will be described in Examples later.
This thermal conductivity can be adjusted by selecting, as appropriate, the type, shape and content of the thermally conductive filler, and the like.
The thermal emissivity is 0.7 or higher, preferably 0.75 or higher, and more preferably 0.8 or higher. If this thermal emissivity is less than 0.7, the heat dissipation is not sufficient. The measurement method of the thermal emissivity will be described in Examples later.
This thermal emissivity can be adjusted by selecting, as appropriate, the type, shape and content of the thermally conductive filler, and the like.
Further, in the heat-dissipating resin composition of the present invention, the bending distortion according to ISO 178 is preferably 1.0% or higher, more preferably in the range from 1.2% to 8%, and further preferably from 1.5% to 8%. When the above-mentioned bending distortion falls within this range, the characteristic balance between the bending distortion and the rigidity is high, being desirable. If this bending distortion is less than 1.0%, a crack tends to be generated when molded articles comprising the heat-dissipating resin composition of the present invention, which serve as a variety of members, are fitted, incorporated or otherwise handled.
This bending distortion can be adjusted by selecting, as appropriate, the type and content of the thermoplastic resin, the type, shape and content of the thermally conductive filler, and the like.
Moreover, the whiteness is preferably 80% or higher, more preferably in the range from 85% to 100%, and further preferably from 87% to 100%. As this whiteness becomes higher, the light reflective characteristic from an LED element is more excellent. The whiteness can be measured with a Hunter color difference meter.
This whiteness can be adjusted by selecting, as appropriate, the type and content of the thermoplastic resin, the type, shape and content of the thermally conductive filler, the type and content of the coloring agent, and the like.
Moreover, in the heat-dissipating resin composition of the present invention, the optical reflectivity is preferably 50% or

higher, more preferably 60% or higher, and further preferably 70% or higher. The measurement method of the optical reflectivity will be described in Examples later.
Regarding the insulation of the heat-dissipating resin composition, the surface specific resistance (an index for insulation; the higher value, the more excellent insulation) of the molded article comprising the heat-dissipating resin composition of the present invention is preferably $1 \times 10^{13}$ Ω or higher, and more preferably $1 \times 10^{14}$ Ω or higher. When it falls within this range, the insulation is excellent.
Since the heat-dissipating resin composition of the present invention has excellent characteristics described above, it is suitable for the formation of a substrate for LED mounting or a reflector placed on this substrate for LED mounting.
The molded article comprising the heat-dissipating resin composition of the present invention has excellent adhesiveness to other members when adhesive or the like is used. Additionally, when gaps between the molded articles or gaps between the molded articles and other members are filled with a sealant or the like and the sealant is cured, a composite member having excellent mechanical strength can be obtained. Examples of the composite member include an illumination device or a light emission device having a substrate for LED mounting; an illumination device or a light emission device having a reflector; an illumination device or a light emission device having a substrate for LED mounting and a reflector; and the like.

2. Molded article

The substrate for LED mounting of the present invention is characterized by comprising the above-mentioned heat-dissipating resin composition of the present invention. In addition, the reflector of the present invention is characterized by comprising the above-mentioned heat-dissipating resin composition of the present invention.
The substrate for LED mounting and reflector of the present invention serve as components of a surface-mounting LED package and can be described with reference to schematic cross-sectional drawings (FIGS. 1 to 3) showing wire bonding mounting.
The surface-mounting LED packages 1 shown in FIGS. 1 and 2 individually have a substrate for LED mounting 11a, a reflector 12, an LED element 13, an electrode 14, an electrically conductive lead 15 connecting the LED element 13 and the electrode 14, a transparent sealing portion (or a space portion) 16 and a lens 17.

2-1. substrate for LED mounting

The substrate for LED mounting of the present invention is usually a flat plate-shaped such as square-shaped and circular. The cross-sectional shape thereof may be evenly flat; on the side where an LED element is placed, a recess portion, a projection portion, a through hole and the like may be formed according to the purpose, the application and the like. For example, as shown in FIG. 1, a recess portion is formed on one side of a substrate 11a and an LED element 13 is placed on the bottom of the recess portion.
Additionally, in the surface of the substrate 11a wherein the LED element 13 are not placed, grooves or the like may be provided to, for example, increase the surface area for the purpose of improving heat dissipation.
The substrate for LED mounting of the present invention may be a large substrate that can have a plurality of LED elements or may be a small substrate that can have one LED element. Thus, the size of the substrate for LED mounting of the present invention is selected according to the purpose, the application and the like.
The thickness (thickness of a portion where the recess portion, the projection portion and the like are not formed) of the substrate for LED mounting of the present invention is selected according to the purpose, the application and the like.
The surface-mounting LED packages 1 shown in FIGS. 1 and 2 are embodiments produced by individually preparing a substrate for LED mounting 11a and a reflector 12 that reflects light emitted by the LED element 13 in a predetermined direction and assembling them. A surface-mounting LED package shown in FIG. 3 can be provided. The surface-mounting LED package 1 shown in FIG. 3 has a substrate for LED mounting 11b provided with a reflector portion 12b, an LED element 13, an electrode 14, an electrically conductive lead 15 connecting the LED element 13 and the electrode 14, a transparent sealing portion (or a space portion) 16 and a lens 17. The shape and the like of the reflector portion 12b are the same as the reflector 12 shown in FIGS. 1 and 2 and will be described in "2-2 Reflector", later.
Clearly from FIG. 3, the substrate for LED mounting of the present invention is a substrate for LED mounting 11b (substrate for LED mounting having the reflector portion 12b) where the substrate for LED mounting 11a and the reflector 12 shown in FIG. 1 are continuous can be provided. With the substrate for LED mounting 11b having the reflector portion 12b, it is possible to obtain a surface-mounting LED package using fewer numbers of components and production steps than a conventional production method. It is advantageous in performance and cost. A surface-mounting LED package 3 shown in FIG. 5 that is one example of a conventional surface-mounting LED package is produced as follows: an insulation mount 18 for arrangement of an LED element is displaced on a metallic substrate 11c consisting of metal aluminum or the like; the LED element 13 is arranged on the mount 18; and then a reflector 12 comprising polyphthalamide or the like is further arranged around the LED element 13. However, unlike a metal that needs to be worked, the substrate

for LED mounting 11b can easily be formed into a predetermined shape due to the heat-dissipating resin composition of the present invention without the need for the insulation mount 18 and the reflector.

2-2. Reflector (reflector portion)

The reflector 12 of the present invention may be used in combination with the substrate for LED mounting 11a of the present invention or may be used in combination with a substrate for LED mounting consisting of other material. The reflector 12 of the present invention and the reflector portion 12b in the substrate for LED mounting 11b have a function of reflecting mainly light from the LED element 13 on the inside surface thereof, toward the lens 17.
These are usually shaped according to the shape of the end portions of the lens 17 (junction portions), and are typically cylindrical or annular such as square-shaped, circular and ellipse-shaped. In the schematic cross-sectional drawings of FIGS. 1 and 2, the reflectors 12 are cylindrical (annular). In FIG. 1, the end portion 122 (on the right side of the drawing) of the reflector 12 is in contact with and fixed to the substrate for LED mounting 11a, and the end portion 121 (on the left side of the drawing) of the reflector 12 is in contact with and fixed to the side surface of the substrate for LED mounting 11a. On the other hand, in FIG. 2, all the end surfaces of the reflector 12 are in contact with and fixed to the surface of the substrate for LED mounting 11a. The inner surfaces of the reflector 12 of the present invention and the above-mentioned reflector portion 12b of the substrate for LED mounting 11b may be tapered to point outward as they extend upward in order to increase the degree of directivity of light from the LED element 13 (see FIG. 2).
Further, the reflector 12 of the present invention and the above-mentioned reflector portion 12b of the substrate for LED mounting 11b can function as lens holders when the end portion on the side of the lens 17 is shaped according to the shape of the lens 17.
The reflector 12 of the present invention and the above-mentioned reflector portion 12b of the substrate for LED mounting 11b may have a recess portion, a projection portion, a through hole and the like according to the purpose, the application and the like. For example, the reflector 121 has a through hole and an electrode 14 is arranged via the through holes according to FIG. 1.
Moreover, according to the reflector 12 and the reflector portion 12b of the substrate for LED mounting 11b, a high reflective characteristic to light emitted from an LED element can be obtained when the above-mentioned heat-dissipating resin composition of the present invention has high whiteness. In order to obtain higher reflective characteristic, a light reflective layer may be formed on the inner wall surface. The thickness of the light reflective layer is preferably 25 $\mu$m or less, more preferably 20 $\mu$m or less, and further preferably 15 $\mu$m or less from the viewpoint of, for example, reducing the thermal resistance.

2-3. Surface-mounting LED package

With the substrate for LED mounting and the reflector of the present invention, it is possible to easily obtain surface-mounting LED packages that are mounted by wire bonding (See, FIGS. 1 to 3).
The LED element 13 is a semiconductor chip (a light-emitting member) that emits light (UV or blue light in the case of a white light LED, in general) and has a double-hetero structure in which an active layer formed of, for example, AlGaAs, AlGaInP, GaP or GaN is sandwiched by n-type and p-type clad layers, and is shaped in the form of, for example, a hexahedron, each side having a length of about 0.5 mm. In the case where the LED element 13 is not mounted by wire bonding unlike the above-mentioned case, the electrically conductive lead 15 is not used, and the LED element 13 is mounted, through a bump, on a wiring pattern placed near the LED element 13 by flip chip bonding.
The electrode 14 is a connection terminal for supplying a drive voltage, and is placed via through holes and the like formed in the reflector 12 of the present invention and the reflector portion 12b of the above-mentioned substrate for LED mounting 11b.
The electrically conductive lead 15 serves to an electrically connect the LED element 13 and the electrode 14, and is embedded into the transparent sealing portion 16 when the transparent sealing portion 16 is provided.
The lens 17 is typically made of a resin and can be formed into a variety of shapes according to the purpose, the application and the like and may be colored.
The portions represented by the reference numeral 16 in FIGS. 1 to 3 may be either a transparent sealing portion or a space portion as required. This portion is usually a transparent sealing portion filled with a material that provides translucency and insulation. With this portion, it is possible to prevent electrical failures caused when, in wire-bonding mounting, the electrically conductive lead 15 is disconnected, cut or short-circuited from the connection portion of the LED element 13 and/or the connection portion of the electrode 14 due to a force applied by direct contact to the electrically conductive lead 15 and a vibration, an impact and the like applied indirectly. Additionally, it is possible not only to protect the LED element 13 from moisture, dust and the like but also to maintain reliability for a prolonged period.
As required, the above-mentioned transparent sealing portion converts the wavelength of light emitted from the LED element into a predetermined wavelength, and may contain inorganic and/or organic fluorescent material.

Examples of the material (a transparent sealant composition) that provides translucency and insulation include generally a silicone, an epoxy silicone, an epoxy-based resin, an acryl-based resin, a polyimide-based resin, a polycarbonate resin and the like. Among them, a silicone is more preferable in terms of heat resistance, weather resistance, low contraction and resistance to discoloration. Additionally, the component may be used singly or in combination of two or more types thereof. This transparent sealant composition is preferably a composition that is obtained by mixing a curable component of the above-mentioned components, a curing agent for curing the component, a curing catalyst as required and the like.
The transparent sealant composition may contain a fluorescent material, a reaction inhibitor, an antioxidizing agent, a light stabilizer, a discoloration inhibitor and the like.
The transparent sealant composition comprising a silicone will be described. A rubber or a resin may be used as the silicone. The composition may be of an addition reaction curing type, a condensation reaction curing type, a UV-curing type or the like. The composition of an addition reaction curing type is preferable because it can be cured quickly. Among others, a composition of a roomtemperature curing type or a heat curing type is preferable.
The composition of an addition reaction curing type is preferably a composition that is obtained by mixing a silicone, a curing agent for curing the silicone, and a curing catalyst or the like as required. This composition is typically consisting of a silicone having a functional group such as vinyl group, a polymer having a Si-H bond in its molecule, a curing catalyst such as a platinum-based catalyst and a palladium-based catalyst. Products manufactured by Dow Corning Toray Co., Ltd. or the like can be used as the composition.
The other components contained, as required, in the above-mentioned transparent sealant composition comprising a silicone are described above. The composition is prepared so as not to contain a curing prevention material. In the case where a molded article comprising the heat-dissipating resin composition of the present invention contains a curing prevention material, when the transparent sealant composition is used, it is likely that an addition reaction does not proceed or hardly proceeds. As a result of this, the adhesiveness to the molded article is reduced. For example, in the case where the heat-dissipating resin composition of the present invention contains a phosphate-based flame retardant or the composition contains a hindered amine-based light stabilizer having the following structure, the curing of the transparent sealant composition is likely to be insufficient.

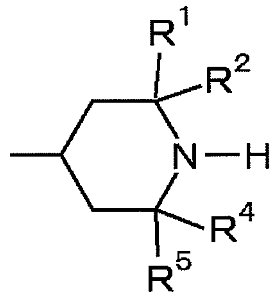

[In the formula, $R^1$, $R^2$, $R^4$ and $R^5$ are either the same as each other or different from each other and are an alkyl group having 1 to 10 carbon atoms, an aryl group having 6 to 20 carbon atoms or an aralkyl group having 7 to 20 carbon atoms.]
Hence, when additives are contained in the heat-dissipating resin composition, additives other than curing prevention materials are selected. It is noted that the curing prevention material is typically dependent on the type of a curing catalyst, and, for example, the following compounds are known as curing prevention materials: an organic compound containing nitrogen element such as an amine compound, an amide compound, a nitrile compound, a cyanate compound, an oxymo compound, a nitroso compound, a hydrazo compound, an azo compound and a chelate compound; an organic compound containing phosphorous element such as a phosphine compound and a phosphite ester; an organic compound containing sulfur element such as a sulfide and a thio compound; an ionic compound containing element such as tin element, arsenic element, antimony element, selenium element, tellurium element and lead element; an organic compound having multiple bonds such as acetylene; and the other compounds.
Hereinafter, an example of a method for the production of a surface-mounting LED package shown FIG. 1 mounted by wire bonding is described.
The heat-dissipating resin composition of the present invention is subjected to molding such as injection molding with a mold having a cavity space of a predetermined shape, into a flat plate-shaped substrate for LED mounting 11a having an recess portion and a cylindrical (annular) reflector 12 having a through hole through which an electrode 14 is fitted by insertion from the inner surface to the outer surface. Thereafter, an LED element 13, an electrode 14 and an electrically conductive lead prepared separately are fixed to the substrate for LED mounting 11a and the reflector 12 by an adhesive or a connecting member. Subsequently, a transparent sealant composition comprising a silicone and the like is injected

into the recess portion formed by the substrate for LED mounting 11a and the reflector 12, and cured by heating, drying and otherwise handling to form a transparent sealing portion 16. Then, a lens 17 is placed at an upper side of the transparent sealing portion 16 to obtain the surface-mounting LED package shown in FIG. 1. Alternatively, it is possible to place the lens 17 in a state where the transparent sealant composition is not cured and thereafter cure the composition.

2-4. LED illumination device

With a surface-mounting LED package having the substrate for LED mounting of the present invention, a surface-mounting LED package having the reflector of the present invention, or a surface-mounting LED package having the substrate for LED mounting provided with the reflector portion of the present invention, it is possible to obtain an LED illumination device. A schematic cross-sectional drawing of the LED illumination device using the surface-mounting LED package in FIG. 1 is shown in FIG. 4.
The LED illumination device 2 shown in FIG. 4 is configured to have two surface-mounting LED packages and has a surface-mounting LED package of FIG. 1, a wiring pattern 22 connecting the electrode 14 of this surface-mounting LED package and a power supply (not shown) for applying a bias voltage to allow the LED element to emit light, and a substrate for illumination device 21 containing this wiring pattern 22. Moreover, a housing may be provided that covers these surface-mounting LED packages and the substrate for illumination device 21.

The configuration of the substrate for illumination device 21 is not particularly limited and may be a 2-layer type substrate in which a substrate 211 (preferably a resin insulated heat-dissipating substrate) and a substrate 212 (preferably a resin insulated heat-dissipating substrate) are stacked and the substrate 211 comprises a wiring pattern, as shown in FIG. 4. It is noted that since the surface-mounting LED package (of FIG. 1) has the substrate for LED mounting 11a excellent in heat dissipation and insulation in FIG.4, a lower side portion of the above-mentioned substrate for LED mounting 11a in the substrate 211 and the substrate 212 has an opening such as through hole.

[Examples]

Hereinafter, the present invention is described in detail using Examples. The present invention is in no way limited by these Examples. In addition, "part" and "%" in the examples are based on weight unless otherwise indicated.

1. Production and evaluation of heat-dissipating resin composition

The starting materials for compositions used in the following Examples and Comparative examples will be shown.

1-1. Thermoplastic resin

(1) A1; Copolymer-type polybutylene terephthalate (modified PBT provided with flexibility; a copolymer of dimethyl telephtalate, 1,4-butanediol and poly tetramethylene glycol)
"NOVADURAN 5505S" (trade name) manufactured by Mitsubishi Engineering Plastics Co. Ltd. was used. Glass transition temperature thereof is 27˚C.
(2) A2; Homo-type polybutylene terephthalate
"NOVADURAN 5007" (trade name) manufactured by Mitsubishi Engineering Plastics Co. Ltd. was used. Glass transition temperature thereof is 30˚C.
(3) A3; Homo-type polyethylene terephthalate
"NOVAPEX GM700Z" (trade name) manufactured by Mitsubishi Chemical Co. Ltd. was used. Weight average molecular weight thereof is 18,000. Glass transition temperature thereof is 67˚C.
(4) A4; Polycarbonate
"NOVAREX 7022PJ-LH1" (trade name) manufactured by Mitsubishi Engineering Plastics Co. Ltd. was used. Weight average molecular weight thereof is 18,000.
(5) A5; Rubber-reinforced resin
"TECHNO ABS170" (trade name) manufactured by Techno Polymer Co. Ltd. was used.

1-2. Thermally conductive filler

(1) B1; Boron nitride
"PT350" (trade name) manufactured by GE specialty materials Japan Co. Ltd. was used. Crystal structure is hexagonal and an average diameter is 130 μm (sieving method). Content of iron oxide is 0%.
(2) B2; Boron nitride
"PT120" (trade name) manufactured by GE specialty materials Japan Co. Ltd. was used. Crystal structure is hexagonal and an average diameter is 12μm (liquid sedimentation method (light transmission method)). Content of iron oxide is 0%.
(3) B3; Boron nitride
"UHP-EX" (trade name) manufactured by Showa Denko K.K. was used. Crystal structure is hexagonal and an average diameter is in the range from 30 to 40 μm (liquid sedimentation method (light transmission method)). Content of iron oxide is 0%.
(4) B4; Boron nitride
"UHP-2" (trade name) manufactured by Showa Denko K.K. was used. Crystal structure is hexagonal and an average diameter is 8 μm (liquid sedimentation method (light transmission method)). Content of iron oxide is 0%.
(5) B5; Zinc oxide
"ZINC OXIDE No. 2" (trade name) manufactured by Sakai Chemical Industry Co., Ltd. was used. Average diameter is 3 μm (laser diffractometry). Content of iron oxide is 0.0007%.
(6) B6; Graphite particle
"HF-150A" (trade name) manufactured by Chuetsu Graphite Works Co., Ltd. was used. Shape thereof is scaly, aspect ratio thereof is 16 and a weight average diameter is 161 μm (electron microscopy).
(7) B7; Boron nitride
"Denka born nitride powder SGP" (trade name) manufactured by Denki Kagaku Kogyo Kabushiki Kaisya was used. Crystal structure is hexagonal and an average diameter is 18.0 μm. Content of iron oxide is 0%.

1-3. Flame retardant

(1) C1; Halogen-based flame retardant
"Epicoat 5203" (trade name) manufactured by Tohto Kasei Co., Ltd. was used.
(2) C2; Aromatic condensation phosphate ester
1,3-phenylenebisdixylenylphosphate (trade name "PX-200" manufactured by Daihachi Chemical Industry Co., Ltd.) was used.

1-4. Ultraviolet absorber (D1)

2-(2'-hydroxy-5'-methylphenyl)benzotriazole (trade name "TINUVIN P" manufactured by Chiba specialty chemicals Co. Ltd.) was used.

1-5. Light stabilizer

(1) E1; Bis(2,2,6,6-tetramethyl-4-piperidyl)sebacate
"Adeka stab LA-77" (trade name) manufactured by Adeka Corporation was used.
(2) E2; Tetrakis(1,2,2,6,6-pentamethyl-4-piperidyl)-1,2,3,4-butanetetracarboxylate
"Adeka stab LA-52" (trade name) manufactured by Adeka Corporation was used.

1-6. Inorganic white pigment (F1)

Titanium oxide (trade name "TIPAQUE PF691" manufactured by Ishihara Sangyo Kaisha, Ltd.) was used.

1-7. Production and evaluation of heat-dissipating resin composition (I)

Examples 1 to 15 and Comparative Examples 1 to 3

(1) Method of producing heat-dissipating resin composition

The thermoplastic resin, the thermally conductive filler and other materials in the proportion shown in Tables 1 and 2 were charged into a mixer to mix for five minutes. After that, they were melt, kneaded and extruded, using an extruder (Type "BT-40-S2-30-L" manufactured by PLABOR Co., Ltd.) and a slightly kneading type screw, at a screw speed of 100 rpm at a cylinder temperature of 260˚C to obtain pellets (heat-dissipating resin composition).

(2) Evaluation method

The pellet thus obtained was used to perform tests for evaluating the following items. The results of the tests were shown in Tables 1 and 2.

[1] Thermal emissivity

The pellet of the heat-dissipating resin composition was injection-molded (mold temperature; 50˚C to 80˚C) into a test piece having a size of 150 mm × 150 mm × 3 mm, and the thermal emissivity thereof was measured with a thermo spot sensor (Type "TSS-5X" manufactured by Japan Sensor Co., Ltd.) by infrared ray detecting reflective energy measurement at an ambient temperature of 25˚C.

[2] Thermal conductivity (unit; W/(m•K))

The pellet of the heat-dissipating resin composition was melt, and the molten material was injected, from the back of a mold (mold temperature; 50˚C to 80˚C) having a cavity space 10 mm in diameter and 50 mm in length, to produce a cylindrical member 10 mm in diameter and 50 mm in length. After that, it was cut in the middle portion into a disc whose thickness was 1.5 mm, and the disc was used as a test piece (10 mm in diameter and 1.5 mm in thickness). In order to measure the thermal conductivity in a direction in which the heat-dissipating resin composition flows, probes were brought into contact with the upper surface and the lower surface of the test piece, and measurement was made at a temperature of 25˚C with a laser flash method thermal constant measuring device (Type "TR-7000R" manufactured by ULVAC-RIKO Inc.).

[3] Thermal deformation temperature (unit; ˚C)

The thermal deformation temperature was measured according to ISO 75 under a load of 1.80 MPa.

[4] Bending distortion (unit; %)

The pellet of the heat-dissipating resin composition was injection-molded (mold temperature; 50˚C to 80˚C) into a test piece having a size of 150 mm × 150 mm × 3 mm, and the bending distortion thereof was measured according to ISO 178 with a precision universal tester (Type "Autograph AG-10KNI" manufactured by Shimadzu Corporation) by three-point strength measurement. The measurement was made on condition that the span interval of the test piece was 64 mm and the bending speed was 1 mm/minute.

[5] Charpy impact strength (unit; $kJ/m^2$)

The Charpy impact strength (edgewise impact, with a notch) was measured according to ISO 179 at a room temperature. The measuring conditions were shown below.

| | | |
|---|---|---|
| Specimen type | : | Type 1 |
| Notch type | : | Type A |
| Load | : | 2J |

[6] Surface specific resistance (unit; Ω)

The pellet of the heat-dissipating resin composition was injection-molded (mold temperature; 50˚C to 80˚C) into a circular test piece having a diameter of 200 mm and a thickness of 2 mm, and the surface specific resistance was measured with a high resistance meter (Type "4339B" manufactured by Agilent Technologies Inc.).

[7] Whiteness (unit; %)

With respect to the whiteness before and after the light resistance test, Lab values (L; lightness, a; redness, b; yellowness) of the same test piece as the above item [1] were measured with a Hunter color difference meter, and the whiteness were calculated by the following equation.

$$W = 100 - \sqrt{(100-L)^2 + a^2 + b^2}$$

The light resistance test was measured with a weather/light resistance tester ("Sunshine weather meter" manufactured by Suga Test Instruments Co., Ltd.) without rain at a temperature of 63˚C while lighting was performed continuously for 1,000 hours.
With respect to Comparative Example 3, the color of the test piece was visually evaluated.

[8] MFR (unit; g/10 minutes)

The MFR of the heat-dissipating resin composition was measured according to ISO 1133 at a temperature of 250˚C under a load of 2kg.

[9] Optical reflectivity (unit; %)

With respect to the reflectivity of ultraviolet rays (having a wavelength of 460 nm) before and after the light resistance test, the test piece same as the above item [2] was used to measure under the same conditions as the above item [7] with a ultraviolet/visible/near-infrared spectrophotometer (Type "V-670" manufactured by JASCO Corporation) at an incident angle of 60 degree.

[10] Curability of transparent sealant composition

A two-component elastomer containing silicone (Trade name "JCR6115" manufactured by Toray Dow Corning Co., Ltd.) was mixed in the weight ratio of 1 to 1 to prepare an addition reaction curing type composition. After that, the composition was defoamed, and an about three gram of the resulting composition was applied on one side of the same test piece as the above item [1], and the coating film of even thickness was formed. Subsequently, it was heated in a gear oven at a temperature of 150˚C for one hour, and the curing condition was evaluated visually and by feeling with a hand.

○ : More than 75% of the area covered by the coating film was cured.
Δ : 25% to 75% of the area covered by the coating film was cured.
× : Less than 25% of the area covered by the coating film was cured.

Comparative Example 4

With respect to a metal aluminum plate, thermal emissivity and thermal conductivity thereof were measured. The results were shown in Table 2.
Table 1

| | | | Example | | | | | | | | |
|---|---|---|---|---|---|---|---|---|---|---|---|
| | | | 1 | 2 | 3 | 4 | 5 | 6 | 7 | 8 | 9 |
| Heat-dissipating resin composition | Mixed amount (parts) | Thermoplastic resin | | | | | | | | | |
| | | A1 | 60 | 50 | 40 | 30 | 60 | 60 | 60 | 20 | 20 |
| | | A2 | | | | | | | | 40 | |
| | | A3 | | | | | | | | | 40 |
| | | Thermally conductive filler | | | | | | | | | |
| | | B1 | 40 | 50 | 60 | 70 | | | | 40 | 40 |
| | | B2 | | | | | 40 | | | | |
| | | B3 | | | | | | 40 | | | |
| | | B4 | | | | | | | 40 | | |
| | | B5 | | | | | | | | | |
| Evaluation | | Thermal emissivity | 0.95 | 0.93 | 0.92 | 0.91 | 0.95 | 0.95 | 0.95 | 0.95 | 0.95 |
| | | Thermal conductivity | 3.5 | 4.5 | 5.5 | 7.5 | 2.8 | 2.0 | 2.3 | 3.5 | 3.5 |
| | | Thermal deformation temperature | 145 | 155 | 165 | 175 | 145 | 145 | 140 | 150 | 175 |
| | | Bending distortion | 3.0 | 2.5 | 2.2 | 2.0 | 4.5 | 3.5 | 4.8 | 1.5 | 1.0 |
| | | Charpy impact strength | 3.0 | 2.5 | 1.5 | 1.0 | 3.5 | 3.5 | 4.0 | 1.0 | 1.0 |
| | | Surface specific resistance | $>10^{15}$ | $>10^{15}$ | $>10^{15}$ | $>10^{15}$ | $>10^{15}$ | $>10^{15}$ | $>10^{15}$ | $>10^{15}$ | $>10^{15}$ |
| | | Whiteness (before light resistance test) | 94 | 94 | 95 | 95 | 94 | 94 | 95 | 95 | 95 |
| | | Whiteness (after light resistance test) | 63 | - | - | - | - | - | - | - | - |
| | | Reflectivity (before light resistance test) | 82 | - | - | - | - | - | - | - | - |
| | | Reflectivity (after light resistance test) | 46 | - | - | - | - | - | - | - | - |
| | | MFR of heat-dissipationg resin composition | 12 | 10 | 7 | 2 | 25 | 12 | 30 | 15 | 2 |
| | | Thermosetting property of transparent sealant composition | ○ | ○ | ○ | ○ | ○ | ○ | ○ | ○ | ○ |

Table 2

| | | | Example | | | | | | Comparative Example | | | |
|---|---|---|---|---|---|---|---|---|---|---|---|---|
| | | | 10 | 11 | 12 | 13 | 14 | 15 | 1 | 2 | 3 | 4 |
| Heat-dissipating resin composition | Mixed amount (parts) | Thermoplastic resin | | | | | | | | | | |
| | | A1 | | 45 | 60 | 40 | 50 | 53 | 82 | | 60 | |
| | | A2 | 45 | | | | | | | | | |
| | | A3 | | | | | | | | | | |
| | | A4 | 5 | 5 | | | | | | 40 | | |
| | | A5 | 10 | 10 | | | | | | 30 | | |
| | | Thermally conductive filler | | | | | | | | | | |
| | | B1 | 40 | 40 | 30 | 30 | 40 | 40 | 18 | 30 | | |
| | | B2 | | | | | | | | | | |
| | | B3 | | | | | | | | | | |
| | | B4 | | | | | | | | | | |
| | | B5 | | | 10 | 30 | | | | | | |
| | | B6 | | | | | | | | | 40 | |
| | | Flame retardant | | | | | | | | | | |
| | | C1 | | | | | 10 | | | | | |
| | | C2 | | | | | | 7 | | | | |
| Evaluation | | Thermal emissivity | 0.95 | 0.95 | 0.93 | 0.91 | 0.95 | 0.95 | 0.95 | 0.95 | 0.68 | 0.08 |
| | | Thermal conductivity | 3.5 | 3.5 | 2.1 | 3.0 | 3.5 | 3.5 | 1.5 | 2.5 | 4.0 | 260 |
| | | Thermal deformation temperature | 120 | 120 | 140 | 145 | 155 | 160 | 139 | 90 | 140 | – |
| | | Bending distortion | 4.3 | 6.0 | 3.0 | 2.1 | 2.5 | 2.5 | 5.0 | 5.0 | 2.0 | – |
| | | Charpy impact strength | 4.5 | 5.5 | 3.2 | 1.0 | 2.5 | 2.5 | 5.8 | 3.0 | 1.5 | – |
| | | Surface specific resistance | $>10^{15}$ | $>10^{15}$ | $>10^{15}$ | $>10^{15}$ | $>10^{15}$ | $>10^{15}$ | $>10^{15}$ | $>10^{15}$ | $1\times10^{7}$ | – |
| | | Whiteness (before light resistance test) | 94 | 94 | 95 | 95 | 95 | 95 | 82 | 90 | 6 | – |
| | | MFR of heat-dissipationg resin composition | 4 | 4 | 14 | 2 | 15 | 15 | 35 | 15 | 5 | – |
| | | Thermosetting property of transparent sealant composition | ○ | ○ | ○ | ○ | △ | △ | ○ | ○ | ○ | – |

Clearly from the results in Table 2, in Comparative Example 1, since the content of the thermally conductive filler is insufficient and thus the thermal conductivity falls below the range specified by the present invention, it is not suitable for the molded material for the substrate for LED mounting and the reflector of the present invention. Comparative Example 2 is an example in which thermoplastic resin having a low thermal deformation temperature was used. Since the thermal deformation temperature falls below the range specified by the present invention, it is not suitable for the molded material for the substrate for LED mounting and the reflector of the present invention.
Additionally, Comparative Example 3 is an example in which graphite particles were used as the thermally conductive filler. Since the composition is black in color and has lower electrical insulation, the composition is not suitable for the molded material for the substrate for LED mounting and the reflector of the present invention.

1-8. Production and evaluation of heat-dissipating resin composition (II)

Examples 16 to 22

(1) Method of producing heat-dissipating resin composition

The thermoplastic resin, the thermally conductive filler, the ultraviolet absorber, the light stabilizer and the inorganic white pigment in the proportion shown in Table 3 were charged into a mixer to mix for five minutes. After that, they were melt, kneaded and extruded, using an extruder (Type "BT-40-S2-30-L" manufactured by PLABOR Co., Ltd.) and a slightly kneading type screw, at a screw speed of 100 rpm at a cylinder temperature of 260˚C to obtain a pellet (heat-dissipating resin composition).

(2) Evaluation method

The pellets thus obtained were used to perform tests for evaluating the above items [1] to [10]. The results of the tests were shown in Table 3.
Table 3

| | | | Example | | | | | | |
|---|---|---|---|---|---|---|---|---|---|
| | | | 16 | 17 | 18 | 19 | 20 | 21 | 22 |
| Heat-dissipating resin composition | Mixed amount (parts) | Thermoplastic resin | | | | | | | |
| | | A1 | 60 | 60 | 60 | 60 | 60 | 60 | 60 |
| | | Thermally conductive filler | | | | | | | |
| | | B7 | 40 | 40 | 40 | 40 | 40 | 40 | 40 |
| | | Ultraviolet absorber | | | | | | | |
| | | D1 | | | 0.5 | 0.5 | | | 0.5 |
| | | Light stabilizer | | | | | | | |
| | | E1 | | | 0.5 | | 0.5 | | |
| | | E2 | | | | | | 0.5 | 0.5 |
| | | Inorganic white pigment | | | | | | | |
| | | F1 | | 10 | 10 | 10 | 10 | 10 | 10 |
| Evaluation | | Thermal emissivity | 0.95 | 0.95 | 0.95 | 0.95 | 0.95 | 0.95 | 0.95 |
| | | Thermal conductivity | 3.8 | 4.0 | 4.0 | 4.0 | 4.0 | 4.0 | 4.0 |
| | | Thermal deformation temperature | 150 | 160 | 160 | 160 | 160 | 160 | 160 |
| | | Bending distortion | 3.0 | 2.8 | 2.8 | 2.8 | 2.8 | 2.8 | 2.8 |
| | | Charpy impact strength | 4.5 | 3.2 | 3.0 | 3.0 | 3.0 | 3.0 | 3.0 |
| | | Surface specific resistance | $>10^{15}$ | $>10^{15}$ | $>10^{15}$ | $>10^{15}$ | $>10^{15}$ | $>10^{15}$ | $>10^{15}$ |
| | | Whiteness (before light resistance test) | 95 | 98 | 98 | 98 | 98 | 98 | 98 |
| | | Whiteness (after light resistance test) | 64 | 68 | 83 | 73 | 73 | 75 | 83 |
| | | Reflectivity (before light resistance test) | 83 | 96 | 96 | 96 | 96 | 96 | 96 |
| | | Reflectivity (after light resistance test) | 45 | 47 | 70 | 60 | 55 | 62 | 70 |
| | | MFR of heat-dissipationg resin composition | 15 | 8 | 8 | 8 | 8 | 8 | 8 |
| | | Thermosetting property of transparent sealant composition | ○ | ○ | △ | ○ | △ | ○ | ○ |

1-9. Evaluation of heat-dissipating resin composition (III)

Example 23

The heat-dissipating resin composition of Example 1 was used to heat with a circular silicone rubber heater 5 (40 mm in diameter) placed in the middle of the surface of the test piece 4 made in the above item [1] by applying a predetermined current at an input voltage of 10V through a watt density of 0.5 $W/cm^2$ (see FIG. 6). After a lapse of 10 minutes, the temperature of the surface of the silicon rubber was 55˚C. At the same time, the temperature measured at a position that was marked "X" and located at the upper left corner in FIG. 6 was 48˚C.
It was found that since the heat-dissipating resin composition had a higher thermal conductivity than that of only a resin and a higher thermal emissivity than that of a metal, its temperature was likely to be decreased and the heat was likely to be dissipated.

Comparative Example 5

The metal aluminum plate of Comparative Example 4 was used to heat in the same manner as Example 23. After a lapse of 10 minutes, the temperature of the surface of the silicon rubber was 64˚C. At the same time, the temperature measured at the position that was marked "X" and located at the upper left corner in FIG. 6 was 60˚C.
It was found that since the metal has a high thermal conductivity but a low thermal emissivity and thus the heat was accumulated, its temperature was likely to be increased and the heat was not likely to be dissipated.

2. Production of substrate for LED mounting

Example 24

The pellets of the heat-dissipating resin composition according to Example 1 were melted at a temperature of 260˚C, and the molten material was injected into a mold (mold temperature; 50˚C to 80˚C) having a rectangular cavity space that forms a circular recess portion in the middle to obtain a substrate for LED mounting 11a (length; about 7 mm, width; about 4 mm, thickness; about 1 mm) shown in FIG. 2.

Example 25

The pellets of the heat-dissipating resin composition of Example 1 were melted at a temperature of 260˚C, and the molten material was injected into a cylindrically protruding mold (mold temperature; 50˚C to 80˚C) in which through holes having electrodes connected to an LED element and fitted by insertion were formed in the protruding inner wall and in which a rectangular cavity space that formed a circular recess portion on the side of its end from the middle to obtain a substrate for LED mounting 11b (about 10 mm high, about 4 mm wide and about 2 mm high at the maximum in a reflector portion) having the reflector portion shown in FIG. 3.

Example 26

A substrate for LED mounting 11a shown in FIG. 2 was obtained in the same manner as Example 24 except that the heat-dissipating resin composition of Examples 18 was used instead of the heat-dissipating resin composition of Example 1.

Example 27

A substrate for LED mounting 11b having a reflector portion shown in FIG. 3 was obtained in the same manner as Example 25 except that the heat-dissipating resin composition of Examples 18 was used instead of the heat-dissipating resin composition of Example 1.

Example 28

A substrate for LED mounting 11a shown in FIG. 2 was obtained in the same manner as Example 24 except that the heat-dissipating resin composition of Examples 21 was used instead of the heat-dissipating resin composition of Example 1.

Example 29

A substrate for LED mounting 11b having a reflector portion shown in FIG. 3 was obtained in the same manner as Example 25 except that the heat-dissipating resin composition of Examples 21 was used instead of the heat-dissipating resin composition of Example 1.

Example 30

A substrate for LED mounting 11a shown in FIG. 2 was obtained in the same manner as Example 24 except that the heat-dissipating resin composition of Examples 22 was used instead of the heat-dissipating resin composition of Example 1.

Example 31

A substrate for LED mounting 11b having a reflector portion shown in FIG. 3 was obtained in the same manner as Example 25 except that the heat-dissipating resin composition of Examples 22 was used instead of the heat-dissipating resin composition of Example 1.

3. Production of reflector

Example 32

The pellets of the heat-dissipating resin composition of Example 1 were melted at a temperature of 260˚C, and the molten material was injected into a mold (mold temperature; 50˚C to 80˚C) having a cavity space that formed cylindrical through holes whose inner surface was tapered toward an opening portion and that had electrodes connected to an LED element and fitted by insertion to obtain a substantially cylindrical reflector 12 (about 3 mm in diameter and about 0.5 mm in thickness) shown in FIG. 2.

Example 33

A substantially cylindrical reflector 12 shown in FIG. 2 was obtained in the same manner as Example 32 except that the pellets of the heat-dissipating resin composition of Example 18 were used instead of the pellets of the heat-dissipating resin composition of Example 1.

Example 34

A substantially cylindrical reflector 12 shown in FIG. 2 was obtained in the same manner as Example 32 except that the pellets of the heat-dissipating resin composition of Example 21 were used instead of the pellets of the heat-dissipating resin composition of Example 1.

Example 35

A substantially cylindrical reflector 12 shown in FIG. 2 was obtained in the same manner as Example 32 except that the pellets of the heat-dissipating resin composition of Example 22 were used instead of the pellets of the heat-dissipating resin composition of Example 1.

4. Production of surface-mounting LED package and LED illumination device

Example 36

The flat plate-shaped substrate for LED mounting having a recess portion obtained in Example 24 and the substantially cylindrical reflector obtained in Example 32 were used to produce a surface-mounting LED package as follows, and an LED illumination device in which the surface-mounting LED packages were evenly spaced in five rows and five columns was obtained.
A blue LED element 13 comprising a GaN semiconductor was first placed in the middle of the recess portion of the substrate for LED mounting 11a. After that, the reflector 12 was placed to surround the LED element 13 and the recess portion of the substrate for LED mounting 11a. Subsequently, the electrode 14 was fitted by insertion through the through holes included in the reflector 12, and the LED element 13 and the electrode 14 were connected through conductive

adhesive to the electrically conductive lead 15. Then, in order to embed the LED element 13, the electrode 14 and the electrically conductive lead 15, the transparent sealant composition containing the mixture of two-component elastomer (Trade name "JCR6115" manufactured by Dow Corning Toray Company Ltd.) in the proportion of 1 to 1 (weight ratio) and a YAG fluorescent member was filled into the recess portion and was heated at a temperature of 150˚C and cured into the transparent sealing portion 16. Next, the lens 17 was placed on the transparent sealing portion 16 to obtain a surface-mounting LED package 1 shown in FIG. 2.

Thereafter, the surface-mounting LED packages 1 shown in FIG. 2 were evenly spaced on a substrate for the illumination device formed of an insulation resin in five rows and five columns to obtain an LED illumination device. A cross-sectional view showing a partial structure is shown in FIG. 4. Here, the surface-mounting LED packages 1 were arranged such that the electrode 14 of the surface-mounting LED package 1 was positioned to connect to the wiring pattern 22 that was electrically continuous to the power supply for applying a bias voltage and that the bottom surface of the substrate for LED mounting 11a faced the through holes (opening portions) formed in the above-mentioned substrate for the illumination device.

Example 37

The flat plate-shaped substrate for LED mounting having a recess portion produced in Example 26 and the substantially cylindrical reflector produced in Example 32 were used to produce a surface-mounting LED package 1 shown in Fig. 2 in the same manner as in Example 36, and then an LED illumination device was obtained.

Example 38

The flat plate-shaped substrate for LED mounting having a recess portion produced in Example 26 and the substantially cylindrical reflector produced in Example 33 were used to produce a surface-mounting LED package 1 shown in Fig. 2 in the same manner as in Example 36, and then an LED illumination device was obtained.

Example 39

The flat plate-shaped substrate for LED mounting having a recess portion produced in Example 28 and the substantially cylindrical reflector produced in Example 34 were used to produce a surface-mounting LED package 1 shown in Fig. 2 in the same manner as in Example 36, and then an LED illumination device was obtained.

Example 40

The flat plate-shaped substrate for LED mounting having a recess portion produced in Example 30 and the substantially cylindrical reflector produced in Example 35 were used to produce a surface-mounting LED package 1 shown in Fig. 2 in the same manner as in Example 36, and then an LED illumination device was obtained.

Example 41

The substrate for LED mounting 11b having the reflector portion obtained in Example 25 was used to produce a surface-mounting LED package as follows, and an LED illumination device in which the surface-mounting LED packages were evenly spaced in five rows and five columns was obtained.

A blue LED element 13 comprising a GaN semiconductor was first placed in the middle of the recess portion of the substrate for LED mounting 11b. After that, the electrode 14 was fitted by insertion through the through holes included in the reflector portion 12b, and the LED element 13 and the electrode 14 were connected through conductive adhesive to the electrically conductive lead 15. Subsequently, in order to embed the LED element 13, the electrode 14 and the electrically conductive lead 15, the transparent sealant composition used in Example 36 was filled into the recess portion and was heated at a temperature of 150˚C and cured into the transparent sealing portion 16. Then, the lens 17 was placed on the transparent sealing portion 16 to obtain a surface-mounting LED package 1 shown in FIG. 3.

Subsequently, the surface-mounting LED packages 1 shown FIG. 3 were evenly spaced on a substrate for the illumination device formed of an insulation resin in five rows and five columns in the same manner as in Example 36 to obtain an LED illumination device.

Example 42

The substrate for LED mounting 11b having the reflector portion produced in Example 27 was used to produce an LED illumination device wherein the surface-mounting LED packages were evenly spaced on the substrate for

illumination device formed of an insulation resin in five rows and five columns in the same manner as in Example 41.

Example 43

The substrate for LED mounting 11b having the reflector portion produced in Example 29 was used to produce an LED illumination device wherein the surface-mounting LED packages were evenly spaced on the substrate for illumination device formed of an insulation resin in five rows and five columns in the same manner as in Example 41.

Example 44

The substrate for LED mounting 11b having the reflector portion produced in Example 31 was used to produce an LED illumination device wherein the surface-mounting LED packages were evenly spaced on the substrate for illumination device formed of an insulation resin in five rows and five columns in the same manner as in Example 41.

According to the LED illumination devices produced in Examples 36 to 44, the devices have improved heat dissipation due to the substrate for LED mounting having excellent thermal conductivity and have excellent insulation and heat resistance, it is possible to reduce an increase in the temperature of an LED element that is emitting light. Thus, it is possible to provide excellent light emission efficiency and a longer life of the LED. In particular, the LED illumination devices produced in Examples 37 to 40 and 42 to 44 have high light reflectivity and light resistance on the inner wall surface of a reflector, and thus can obtain stable brightness for a prolonged period. In the LED illumination devices produced in Examples 39, 40, 43 and 44, the composition used for sealing the LED element and the like was superior in curing, and thus its mechanical strength was excellent. The composition is superior in protection performance for the LED element and the like, and thus the LED illumination devices and the like have excellent productivity.

[Industrial Applicability]

The heat-dissipating resin composition is suitable for the formation of a part that is an element in an LED illumination device and is required for heat dissipation, insulation or thermal resistance. Therefore, the composition is preferably used for a substrate for LED mounting, a reflector and the like.

## Claims

1. A heat-dissipating resin composition used for forming a substrate for LED mounting or a reflector disposed on the substrate for LED mounting, **characterized by** comprising a thermoplastic resin and a thermally conductive filler, wherein the heat-dissipating resin composition has a thermal deformation temperature of 120˚C or higher, a thermal conductivity of 2.0 W/(m•K) or higher, and a thermal emissivity of 0.7 or higher.

2. The heat-dissipating resin composition according to Claim 1, wherein a content of the thermally conductive filler is in the range from 20% to 90% by weight based on 100% by weight of a total of the thermoplastic resin and the thermally conductive filler.

3. The heat-dissipating resin composition according to Claim 1 or 2, wherein the heat-dissipating resin composition is electrically insulated.

4. The heat-dissipating resin composition according to any one of Claims 1 to 3, wherein a content of iron oxide in the thermally conductive filler is 0.01% or less by weight.

5. The heat-dissipating resin composition according to any one of Claims 1 to 4, wherein the thermally conductive filler is scaly.

6. The heat-dissipating resin composition according to any one of Claims 1 to 5, wherein the thermally conductive filler is of boron nitride.

7. The heat-dissipating resin composition according to any one of Claims 1 to 6, wherein the thermoplastic resin is a polyester resin, a polycarbonate resin, a polyamide-based polymer or a mixture containing at least two types selected from the group consisting of a rubber-reinforced resin, a polyester resin, a polycarbonate resin and a polyamide-based polymer.

**8.** The heat-dissipating resin composition according to any one of Claim 7, wherein the polyester resin comprises a copolymeric polyester.

**9.** The heat-dissipating resin composition according to any one of Claim 8, wherein the copolymeric polyester comprises a copolymer-type polybutylene terephthalate.

**10.** The heat-dissipating resin composition according to any one of Claims 1 to 9, further comprising a flame retardant.

**11.** The heat-dissipating resin composition according to any one of Claims 1 to 10, further comprising a ultraviolet absorber and/or a light stabilizer in an amount from 0.05 to 10 parts by weight based on 100 parts by weight of a total of the thermoplastic resin and the thermally conductive filler.

**12.** The heat-dissipating resin composition according to Claim 11, wherein the light stabilizer is a hindered amine-based compound having the following structure;

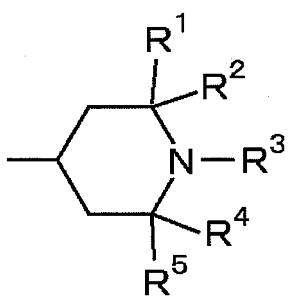

wherein $R^1$, $R^2$, $R^3$, $R^4$ and $R^5$ are either the same as each other or different from each other and are an alkyl group having 1 to 10 carbon atoms, an aryl group having 6 to 20 carbon atoms or an aralkyl group having 7 to 20 carbon atoms.

**13.** The heat-dissipating resin composition according to any one of Claims 1 to 12, wherein bending distortion is 1.5% or higher and whiteness is 80% or higher.

**14.** A substrate for LED mounting **characterized by** comprising the heat-dissipating resin composition according to any one of Claims 1 to 13.

**15.** A reflector **characterized by** comprising the heat-dissipating resin composition according to any one of Claims 1 to 13.

**16.** A substrate for LED mounting having a reflector portion **characterized by** comprising the heat-dissipating resin composition according to any one of Claims 1 to 13.

Figure 1

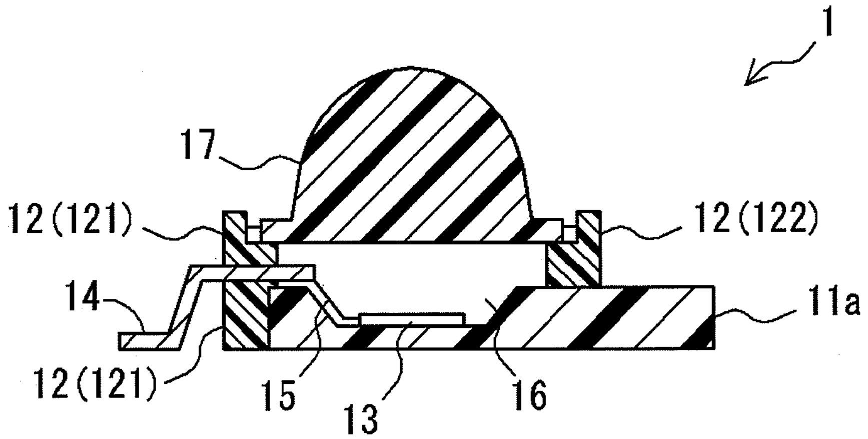


Figure 2

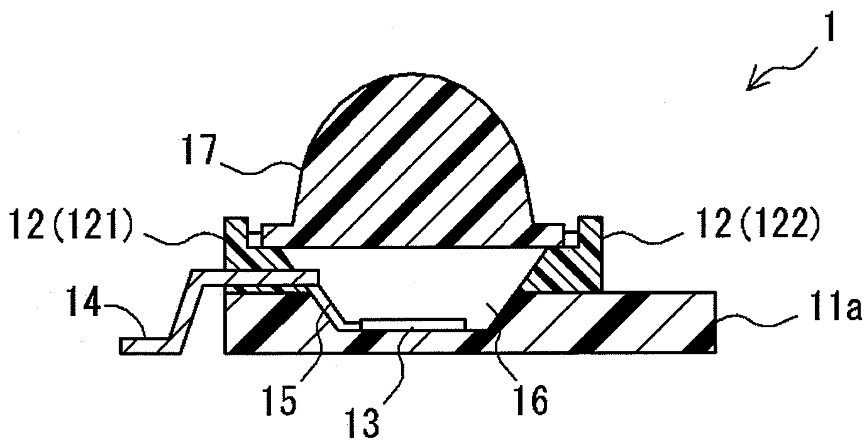


Figure 3

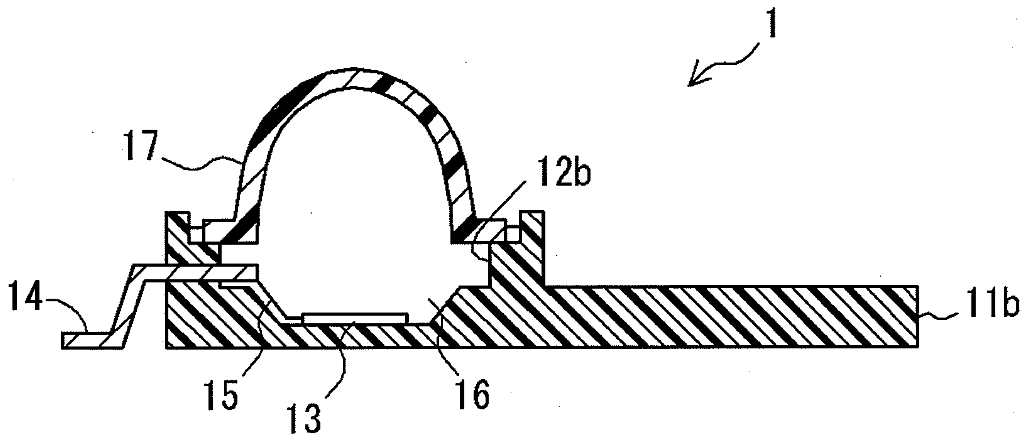

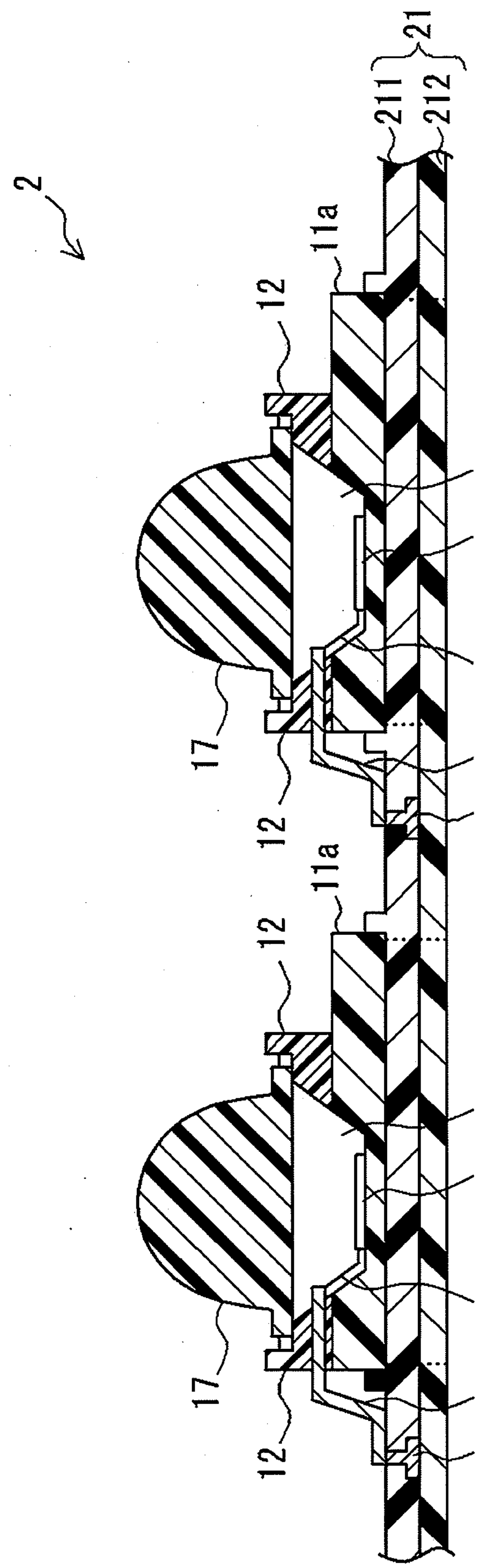


Figure 4

Figure 5

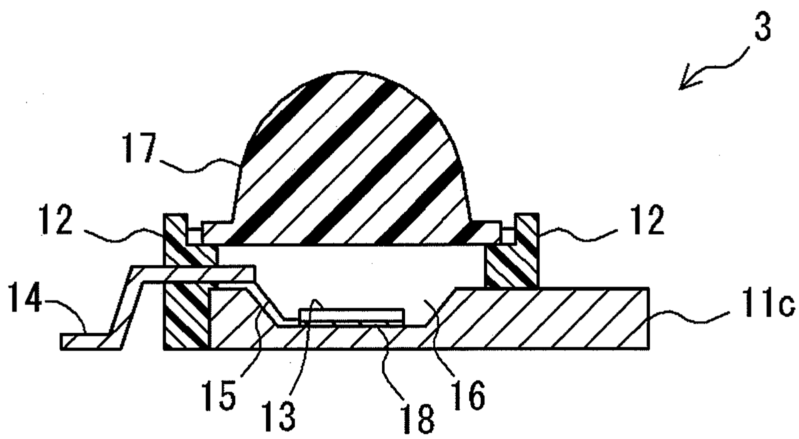


Figure 6

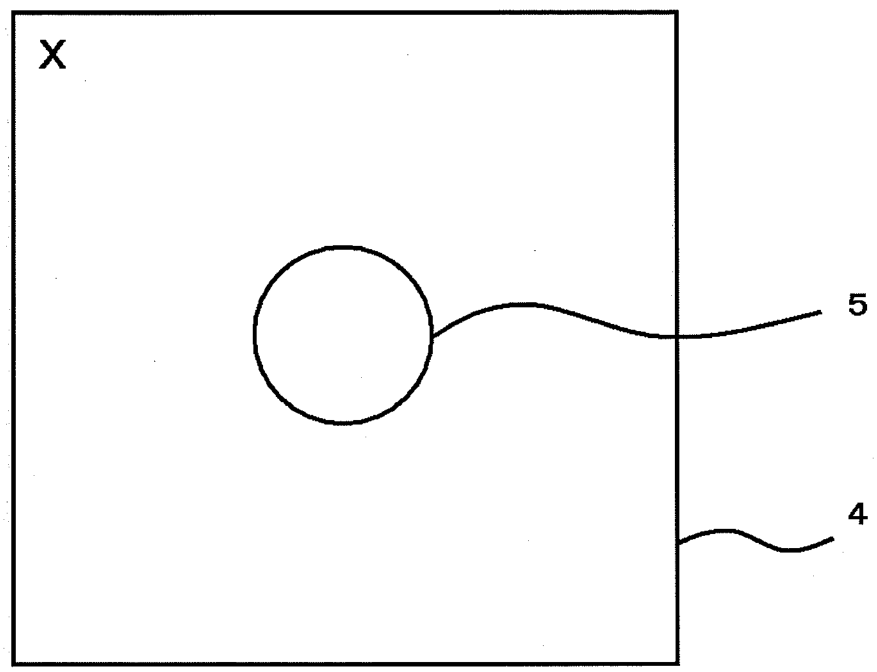

**INTERNATIONAL SEARCH REPORT**

International application No.
PCT/JP2007/070668

A. CLASSIFICATION OF SUBJECT MATTER
*C08L101/00*(2006.01)i, *C08K3/00*(2006.01)i, *H01L33/00*(2006.01)i

According to International Patent Classification (IPC) or to both national classification and IPC

B. FIELDS SEARCHED

Minimum documentation searched (classification system followed by classification symbols)
C08L101/00, C08K3/00, H01L33/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2007-262295 A (Unitika Ltd.), 11 October, 2007 (11.10.07), Claims; Par. Nos. [0019], [0041], [0044]; Par. No. [0050], table 1 (Family: none) | 1-8,10-13 |
| P,X | JP 2007-002231 A (Techno Polymer Co., Ltd.), 11 January, 2007 (11.01.07), Claims; Par. Nos. [0012] to [0076], [0090] to [0107]; Par. No. [0122], table 2; Par. No. [0126], table 4; Par. No. [0129], table 5; Par. No. [0132], table 6 & WO 2006/126606 A1 | 1-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 December, 2007 (19.12.07) | 08 January, 2008 (08.01.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2007/070668

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2004-175812 A (Toray Industries, Inc.),<br>24 June, 2004 (24.06.04),<br>Claims; Par. Nos. [0015] to [0016], [0045] to [0046], [0090], [0107]; Par. No. [0121], table 1; Par. No. [0126], table 2; Par. No. [0128], table 3<br>(Family: none) | 1-13<br>14-16 |
| X<br>Y | WO 2003/021623 A1 (COOL OPTIONS, INC.),<br>13 March, 2003 (13.03.03),<br>Claims; Par. Nos. [0011], [0018] to [0021], [0024] to [0055]<br>& US 2003/043586 A1 & EP 1421595 A1<br>& AU 2002323471 A1 & KR 2004044507 A<br>& BR 200212241 A & US 6827470 B2<br>& AU 2002323471 B2 & CN 1561528 A<br>& IN 200400654 P4 & TW 234632 B1<br>& MX 2004001937 A1 & KR 580895 B1 | 1-13<br>14-16 |
| X<br>Y | JP 2005-325231 A (Sumitomo Chemical Co., Ltd.),<br>24 November, 2005 (24.11.05),<br>Claims; Par. Nos. [0001], [0005] to [0019], [0024]<br>& CN 1696194 A & KR 2006047807 A<br>& US 7214761 B2 | 1-13<br>14-16 |
| Y | JP 2005-166937 A (Toyoda Gosei Co., Ltd.),<br>23 June, 2005 (23.06.05),<br>Claims; Fig. 1<br>(Family: none) | 14-16 |
| A | JP 2002-129015 A (Dainippon Ink And Chemicals, Inc.),<br>09 May, 2002 (09.05.02),<br>Claims<br>(Family: none) | 1-16 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S62149180 A
- JP 2002344031 A
- JP S61233010 A
- JP S5993701 A
- JP S56167704 A